# FASCICULE DE BREVET EUROPEEN

(11) **EP 2 764 616 B1**
(45) Date de publication et mention de la délivrance du brevet: **16.12.2015**
(21) Numéro de dépôt: 12769653.2
(22) Date de dépôt: 05.10.2012
(51) Int. Cl.: H03H 3/04, H03H 9/17, H03H 9/13, H03H 9/02

(54) **TRANSDUCTEUR ÉLECTROACOUSTIQUE À POLARISATION FERROÉLECTRIQUE PÉRIODIQUE RÉALISÉ SUR UNE STRUCTURE VERTICALE MICRO USINÉE**
ELEKTROAKUSTISCHER WANDLER MIT PERIODISCHER FERROELEKTRISCHER POLARISATION AUF EINER MIKROGEFERTIGTEN VERTIKALERN STRUKTUR
ELECTROACOUSTIC TRANSDUCER WITH PERIODIC FERROELECTRIC POLARIZATION PRODUCED ON A MICROMACHINED VERTICAL STRUCTURE

(30) Priorité: 05.10.2011 FR 1158963
(43) Date de publication de la demande: 13.08.2014
(73) Titulaire: Centre National de la Recherche Scientifique (CNRS), 75016 Paris (FR); Université de Franche-Comté, 25030 Besançon Cedex (FR)
(72) Inventeur: BALLANDRAS, Sylvain, F-25000 Besancon (FR); ULLIAC, Gwenn, F-25000 Besancon (FR); EDOUARD-GUICHARDAZ, Blandine, F-25870 Auxon-Dessous (FR); BASSIGNOT, Florent, F-25000 Besancon (FR); COURJON, Emilie, F-25000 Besancon (FR)
(74) Mandataire: Blot, Philippe Robert Emile
(86) Numéro de dépôt international: PCT/EP2012/069709
(87) Numéro de publication internationale: WO 2013/050521

(56) Documents cités:
- WO-A1-02/07310
- JP-A- 2001 044 794
- US-A1- 2006 066 175

## Description

L'invention concerne des transducteurs à polarisation ferroélectrique périodique pour l'excitation d'ondes élastiques guidées dans des structures verticales micro-usinées, et des procédés de fabrication de ces transducteurs.

Les transducteurs à polarisation ferroélectrique périodique sont largement utilisés dans de multiples applications à fréquence de fonctionnement élevée, par exemple en tant que résonateurs jouant le rôle d'éléments d'impédance à fort couplage électromécanique pour des applications aux filtres de fréquences, en tant qu'éléments de filtrage de boucle d'oscillation pour des applications aux sources de fréquence radio, et d'une manière générale en tant que composants passifs pour le traitement de signal radiofréquence appliqués aux capteurs. Il est à remarquer que les structures à polarisation ferroélectrique périodique ont été mises en oeuvre initialement pour les composants optiques de type doubleur de fréquence et qu'à ce titre elles ont été optimisées en termes de réalisation technologique.

Suivant les documents WO 02/07310 A1 et WO 2010/031924 A1, il est connu de réaliser de façon planaire des transducteurs piézoélectriques à polarisation ferroélectrique périodique, c'est-à-dire ayant des domaines ferroélectriques alternés. Ces transducteurs permettent de créer, d'entretenir et de détecter des ondes élastiques guidées entre deux surfaces métalliques dont les vitesses de phase sont de l'ordre de 3800 et 6500 mètres par seconde, et qui sont compatibles avec les applications de filtres et de sources radiofréquence. Toutefois, de tels transducteurs présentent des couplages électroacoustiques assez modestes de quelques fractions de pour-cent.

Le document US2006/066175 décrit un résonateur piézoélectrique ayant sa plaque de transduction piézoélectrique fixée perpendiculairement au substrat.

La recherche de procédés pour fabriquer de façon collective un nombre élevé de transducteurs piézoélectriques à domaines ferroélectriques alternés sur une plaque cristalline reste un sujet d'actualité.

Les procédés développés jusqu'à présent consistent essentiellement à exploiter des méthodes de rodage/polissage de plaques, fixées à plat sur un substrat de soutien, éventuellement par collage.

Cette approche est certes très efficace mais ne permet pas de maîtriser facilement des épaisseurs de plaques inférieures à 10µm.

Le problème technique est donc d'améliorer la fabrication de plaques d'épaisseurs inférieures à 10µm, ou en d'autres termes d'améliorer le rendement de fabrication de plaques de transducteurs piézoélectriques à domaines ferroélectriques alternés pour lesquelles l'épaisseur est inférieure à 10µm.

De manière connexe, un autre problème technique est également d'améliorer l'intégration de plusieurs transducteurs à polarisation ferroélectrique périodique réalisés sur une même tranche de cristal.

Un autre problème technique est de pouvoir réaliser des transducteurs à domaines ferroélectriques alternés permettant d'obtenir des couplages électroacoustiques plus élevés.

A cet effet, l'invention a pour objet un transducteur piézoélectrique à ondes de volume fonctionnant à une fréquence prédéterminée f et comprenant :
un bloc de substrat, porteur, ayant une face plane possédant une première épaisseur e1 suivant une normale de la face plane et constitué en un premier matériau, et
une plaque de transduction piézoélectrique ayant une première et une deuxième faces planes disposées en vis-à-vis, possédant une longueur L, une largeur l et une deuxième épaisseur e2, et constituée en un deuxième matériau piézoélectrique,
une première et une deuxième électrodes métalliques recouvrant au moins en partie et respectivement la première face et la deuxième face de la plaque de transduction piézoélectrique et au moins partiellement en vis à vis,
la plaque de transduction piézoélectrique est formée par une couche de matériau ferroélectrique qui comprend des premiers domaines de polarisation positive et des seconds domaines de polarisation négative, les premiers domaines et les seconds domaines étant répartis dans le sens de la longueur L de la plaque en étant alternés selon un motif de répétition, le motif de répétition étant défini par un pas p et un rapport cyclique, et
la plaque de transduction piézoélectrique est fixée perpendiculairement au voisinage de la face plane du bloc de substrat de sorte que la largeur de la plaque de transduction piézoélectrique et la première épaisseur du bloc de substrat ont un même sens, et
le premier matériau, le deuxième matériau, la première épaisseur du bloc de substrat, la longueur L, la largeur l, la deuxième épaisseur e2 de la plaque de transduction, le pas p sont configurés pour créer et piéger des ondes de volume à la fréquence de fonctionnement du transducteur guidées entre ses deux faces planes, les ondes acoustiques guidées se propageant dans le sens de la longueur L de plaque de transduction.

Suivant des modes de réalisation particulière, le transducteur comporte l'une ou plusieurs des caractéristiques suivantes :
- le matériau possède une coupe cristallographique notée ZX selon le standard IEEE Std-176 Révision 1949, l'axe cristallographique X et l'axe cristallographique Z étant respectivement dirigés selon la longueur L et la largeur l de la plaque de transduction piézoélectrique, les axes de polarisation des domaines ferroélectriques étant colinéaires à l'axe Z et l'axe de périodisation étant dirigé selon l'axe X ;
- le matériau possède trois axes cristallographiques X, Y, Z, une coupe cristallographique notée ZX selon le standard IEEE Std-176 Révision 1949, l'axe cristallographique Y et l'axe cristallographique Z étant respectivement dirigés selon la longueur L et la largeur l de la plaque de transduction piézoélectrique, les axes de polarisation des domaines ferroélectriques étant colinéaires à l'axe Z, et l'axe de périodisation étant dirigé selon l'axe Y ;
- un facteur de forme latéral Fl, défini comme le rapport de la largeur l de la plaque de transduction piézoélectrique sur la deuxième épaisseur e2 de la plaque de transduction piézoélectrique, est supérieur ou égal à 5, de préférence supérieur ou égal à 10;
- un facteur de forme longitudinal, défini comme le rapport de la longueur de la plaque de transduction sur l'épaisseur de la plaque résonnante, est un multiple de longueurs d'ondes supérieur ou égal à 10, de préférence supérieur ou égal à 100, la longueur d'onde étant égale à la vitesse de la phase de l'onde divisée par la fréquence f;
- la plaque de transduction piézoélectrique et le bloc de substrat sont constitués en un même matériau piézoélectrique et forment une pièce d'un seul tenant, dans lequel le bloc de substrat comprend des premiers domaines de polarisation positive et des seconds domaines de polarisation négative, les premiers domaines et le seconds domaines du bloc du substrat étant répartis dans le sens de la longueur de la plaque avec la même répartition des polarisations ferroélectriques que celle de la plaque dans le sens de la longueur L ;
- le transducteur piézoélectrique comprend un élément de fixation et/ou d'isolation acoustique à la fréquence de fonctionnement f distinct du bloc de substrat et de la plaque de transduction piézoélectrique, constitué en au moins un troisième matériau distinct des premier et deuxième matériau, l'élément de fixation et/ou de d'isolation acoustique étant compris dans l'ensemble constitué par une unique couche de colle, un miroir de Bragg formé d'un empilement de couches à impédances acoustiques contrastées ;
- la plaque de transduction piézoélectrique et le bloc de substrat sont constitués en un même matériau piézoélectrique et comprennent des domaines ferroélectriques polarisées selon un même motif avec des directions de polarisations et des sens identiques ;
la coupe cristallographique et les polarisations des domaines ferroélectriques de la plaque de transduction piézoélectrique sont configurés de sorte que des ondes de volume à polarisation transversale ou longitudinale sont crées avec un coefficient de couplage électroacoustique supérieur à 0,01% et guidées entre les deux électrodes en se propageant dans la direction de la longueur de la plaque ;
- la plaque de transduction piézoélectrique présente une zone d'étranglement dans la sens de l'épaisseur sur toute sa longueur pour laquelle l'épaisseur de la plaque de transduction passe par un minimum, et la plaque résonnante étant fixée au bloc de substrat, la zone d'étranglement est située au voisinage de la face plane du bloc de substrat ;
- le premier matériau est compris dans l'ensemble des matériaux formé par le carbone-diamant, le silicium, le saphir, le carbure de silicium, le quartz, le niobate de lithium, le tantalate de lithium, le niobate de potassium, les céramiques piézoélectriques, le quartz, le tétraborate de lithium, l'orthophosphate, de gallium, le langasite, la langatate, le langanite, la silice,
le deuxième matériau est compris dans l'ensemble des matériaux formé par l'oxyde plomb, le titane, le zirconium PZT, le tantalate de lithium LiTaO₃, le niobate de lithium LiNbO₃, le niobate de potassium PbTiO₃ et les matériaux ferroélectriques de haute qualité cristalline ;
- les électrodes métalliques sont fabriquées dans un matériau compris dans l'ensemble des matériaux formés par l'aluminium, le platine, l'iridium, le zirconium, le rubidium, le cuivre, le titane, le molybdène, le nickel, le tungstène, l'or, le poly-silicium, les alliages de ces différents métaux, et
leur épaisseur est répartie de façon à obtenir une répartition de masse localisée en frontière de la plaque résonnante et du bloc de substrat de façon à piéger et concentrer les ondes de volume à l'intérieur d'une zone locale de la plaque résonnante.

L'invention a également pour objet un procédé de fabrication d'un transducteur piézoélectrique à domaines ferroélectriques alternés fonctionnant à une fréquence prédéterminée comprenant les étapes suivantes :
- fournir une couche brute de départ de plaque de transduction piézoélectrique, la couche brute de départ de la plaque de transduction étant constituée en un matériau piézoélectrique et ferroélectrique, ayant une épaisseur de couche brute eb, et une étendue spatiale dans un plan perpendiculaire à la direction de l'épaisseur nettement plus grande que l'épaisseur eb de la couche brute, la couche brut de départ comprenant des premiers domaines de polarisation positive et des seconds domaines de polarisation négative, les premiers domaines et les seconds domaines étant répartis dans le sens d'une longueur de la couche brute en étant alternés selon un motif de répétition, le motif de répétition étant défini par un pas p et un rapport cyclique,
   et l'orientation cristallographique de la couche brute et la direction des polarisations ferroélectriques ayant été au préalable choisies de sorte qu'il existe un plan de coupe cristallographique de la couche brute dans le sens de l'épaisseur eb et de la longueur de la couche brute pour lequel une tranche, découpée suivant le plan de coupe et ayant une épaisseur e2, réalise lorsqu'elle est enserrée par des électrodes métalliques formées dans des plans normaux à la direction de l'épaisseur e2 un transducteur piézoélectrique ferroélectrique à polarisation alternée, dans lequel des ondes de volume guidées se propagent dans le sens de la longueur de la tranche, avec un coefficient de couplage électro-acoustique supérieur ou égal à 0,01%,
- découper dans le sens de l'épaisseur de la couche brute et partiellement ou totalement dans la couche brute de départ de plaque résonnante, une plaque de transduction piézoélectrique ayant une épaisseur de plaque résonante e2, une première et une deuxième faces planes disposées en vis-à-vis, les faces planes possédant une longueur L, une largeur l et, la découpe étant effectuée par un procédé d'usinage suivant la direction de plan de coupe, la largeur l de la plaque et l'épaisseur de la couche brute étant de même sens, le matériau et l'orientation cristallographique de la couche brut, la direction du plan de coupe, la longueur L, la largeur l, la deuxième épaisseur de la plaque résonnante étant configurés pour créer et piéger des ondes de volume à la fréquence de fonctionnement du transducteur entre ses deux faces planes, et pour créer un guide d'ondes acoustiques de volume guidées se propageant dans le sens de la longueur L de la plaque de transduction ; et
- déposer une première et une deuxième électrodes métalliques recouvrant au moins en partie et respectivement la première face et la deuxième face de la plaque de transduction piézoélectrique, et au moins partiellement en vis-à-vis.

Suivant des modes particuliers de réalisation, le procédé de fabrication comporte l'une ou plusieurs des caractéristiques suivantes :
- le procédé de fabrication comprend l'étape consistant à découper partiellement dans la couche de départ et dans le sens de l'épaisseur de la couche de départ la plaque résonnante, la découpe partielle dans le sens de l'épaisseur de la couche brute étant effectuée par enlèvement d'un premier barreau adjacent à la plaque au travers de la première face, et d'un deuxième barreau adjacent à la plaque au travers de la deuxième face,
   de façon à obtenir la plaque résonante et un bloc de substrat comme étant le reste de la couche brute après découpage des barreaux, porteur de la plaque et ayant une face plane de référence, la plaque étant fixée d'un seul tenant perpendiculairement à la face plane du bloc de substrat, la largeur l de la plaque étant ainsi une hauteur de la plaque par rapport au bloc de substrat ;
- le procédé de fabrication comprend les étapes consistant à fournir une couche brute de substrat porteur ayant une épaisseur de couche brute de substrat porteur et constitué en un matériau de substrat, et
   disposer entre la couche de substrat porteur et la couche brute de plaque de transduction au moins une couche destinée à former un élément de fixation et/ou d'isolation acoustique à la fréquence de fonctionnement, distincte de la couche brute de substrat et de couche brute de la plaque résonnante, constituées en au moins un troisième matériau distinct du matériau de couche brute de substrat et distinct de la couche brute de plaque résonante, l'au moins une couche formant l'élément de fixation et/ou de d'isolation acoustique étant comprise dans l'ensemble constitué par une unique couche de colle, un miroir de Bragg formé d'un empilement de couches à impédances acoustiques contrastées,
   découper au moins la couche brut de plaque sur une certaine profondeur de façon à former la plaque de transduction piézoélectrique ; et
- l'étape de découpe de la plaque résonante est réalisée par sciage.

L'invention sera mieux comprise à la lecture de la description de plusieurs formes de réalisation qui va suivre, donnée uniquement à titre d'exemple et faite en se référant aux dessins sur lesquels :
- la Figure 1 est une vue d'une première forme de réalisation d'un transducteur piézoélectrique à domaines ferroélectriques alternés dans lequel le bloc de substrat et la plaque de transduction piézoélectrique sont d'un seul tenant ;
- la Figure 2 est une coupe transversale du transducteur de la Figure 1 dans le sens de la largeur et de l'épaisseur de la plaque de transduction piézoélectrique suivant le plan de coupe II-II de la Figure 1 ;
- la Figure 3 est une coupe transversale du transducteur de la Figure 1 au niveau de la plaque de transduction dans le sens de l'épaisseur et de la longueur de la plaque de transduction suivant le plan de coupe III-III de la Figure 1 ;
- la Figure 4 est une coupe transversale dans le sens de l'épaisseur et de la largeur de la plaque de transduction d'une deuxième forme de réalisation dérivée d'un transducteur piézoélectrique de la Figure 1 dans lequel un goulet d'étranglement sépare la plaque de transduction du bloc de substrat ;
- la Figure 5 est une coupe transversale dans le sens de l'épaisseur et de la largeur de la plaque de transduction d'une troisième forme de réalisation de transducteur, dérivée du résonateur de la Figure 1, qui met en oeuvre une métallisation accrue au niveau des électrodes sur la partie haute du substrat.
- la Figure 6 est une coupe transversale dans le sens de l'épaisseur et de la largeur de la plaque de transduction d'une quatrième forme de réalisation d'un transducteur piézoélectrique, de forme géométrique identique à celle du résonateur de la Figure 1 dans lequel un élément de fixation relie la plaque de transduction au bloc de substrat ;
- la Figure 7 est une coupe transversale dans le sens de l'épaisseur et de la largeur de la plaque de transduction d'une cinquième forme de réalisation d'un transducteur piézoélectrique, de forme géométrique identique à celle du résonateur de la Figure 1 dans lequel un élément d'isolation acoustique relie la plaque de transduction au bloc de substrat ;
- la Figure 8 est un ordinogramme d'un procédé de fabrication du transducteur piézoélectrique de la Figure 1 ;
- la Figure 9 est une vue d'un premier état intermédiaire du transducteur piézoélectrique de la Figure 1 fabriqué par le procédé de la Figure 8 ;
- la Figure 10 est une vue d'un deuxième état intermédiaire du transducteur piézoélectrique de la Figure 1 fabriqué par le procédé de la Figure 8 ;
- la Figure 11 est une vue d'un troisième état intermédiaire du transducteur piézoélectrique de la Figure 1 fabriqué par le procédé de la Figure 8 ;
- la Figure 12 est une vue d'une puce intégrant sur un même substrat un ensemble de plusieurs transducteurs piézoélectriques décrits dans les Figures 1 à 7 ;
- la Figure 13 est un ordinogramme d'un procédé de fabrication du transducteur piézoélectrique de la Figure 6 ou de la Figure 7;
- la Figure 14 est une vue d'un premier état intermédiaire du transducteur piézoélectrique de la Figure 5 ou de la Figure 6 fabriqué par le procédé de la Figure 13 ;
- la Figure 15 est une vue d'un deuxième état intermédiaire du transducteur piézoélectrique de la Figure 6 ou de la Figure 7 fabriqué par le procédé de la Figure 13 ;
- la Figure 16 est une vue d'un troisième état intermédiaire du transducteur piézoélectrique de la Figure 6 ou de la Figure 7 fabriqué par le procédé de la Figure 13 ;

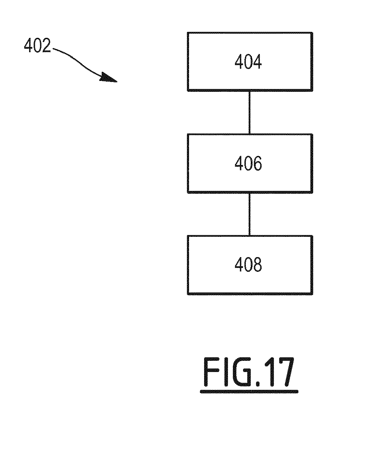

- la Figure 17 est un ordinogramme d'un procédé de fabrication généralisant les procédés de fabrication 8 et 13.

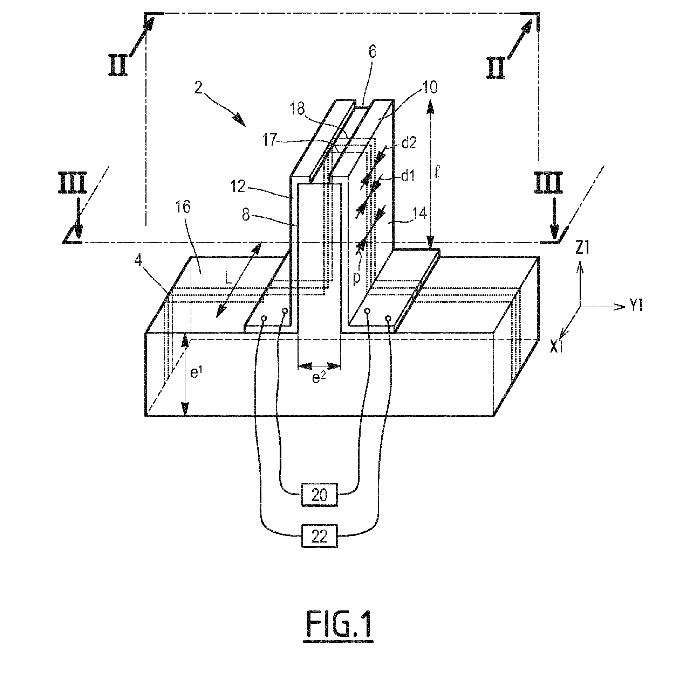

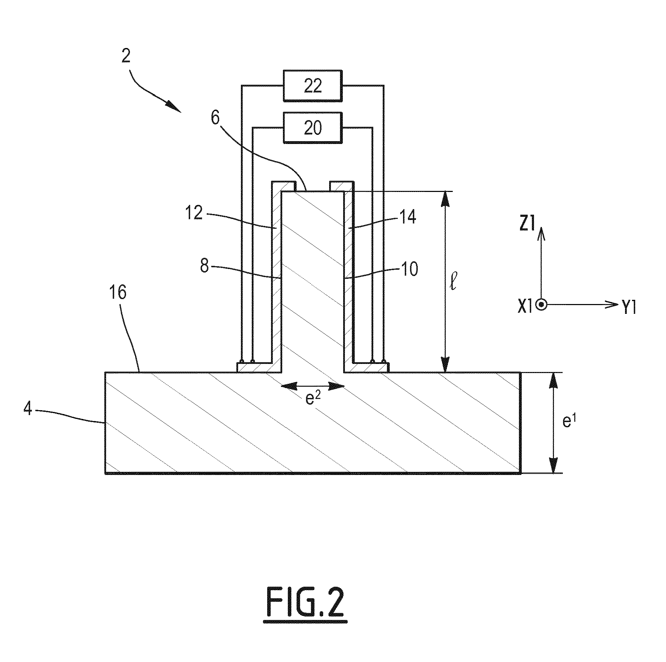

Suivant les Figures 1, 2 et 3, un transducteur piézoélectrique 2 à domaines ferroélectriques alternés, ou en d'autres termes à polarisation ferroélectrique périodique, est configuré pour fonctionner à une fréquence désirée f prédéterminée.

Le transducteur piézoélectrique 2 comprend un bloc de substrat 4, une plaque de transduction piézoélectrique et ferroélectrique 6 ayant une première face 8 et une deuxième face 10 en vis-à-vis, une première électrode métallique 12 déposée sur la première face 8 et une deuxième électrode métallique 14 déposée sur la deuxième face 10 de la plaque de transduction 6.

Le bloc de substrat 4, constitué en un premier matériau, comporte une face plane 16 possédant une première épaisseur e1 suivant une normale de la face plane 16 et sert de support à la plaque de transduction 6.

La plaque de transduction piézoélectrique 6, constituée en un deuxième matériau piézoélectrique, est délimitée par les première et deuxième faces planes 8, 10. Les deux faces 8, 10 de la plaque 6 sont mutuellement parallèles et espacées d'une distance désignée par e2, laquelle distance forme l'épaisseur de la plaque de transduction piézoélectrique 6.

Un repère triédrique à trois axes X1, Y1, Z1 orthogonaux entre eux est défini dans lequel l'axe Z1 est l'axe de la normale à la face plane 16, c'est-à-dire l'axe vertical sur la Figure 1, l'axe Y1 est l'axe dirigé selon le sens de l'épaisseur de la plaque de transduction 6, et l'axe X1 est configuré pour rendre direct le trièdre du repère.

Chaque face 8, 10 de la plaque de transduction 6 possède une longueur L selon l'axe X1 et une largeur l selon l'axe Z1.

Ici, le premier matériau et le deuxième matériau sont identiques et forment un même matériau piézoélectrique et ferroélectrique comprenant des domaines ferroélectriques alternés 17, 18.

Par exemple, le même matériau est du niobate de lithium dans lequel des domaines ferroélectriques à polarisations alternées ont été créés localement et de manière durable.

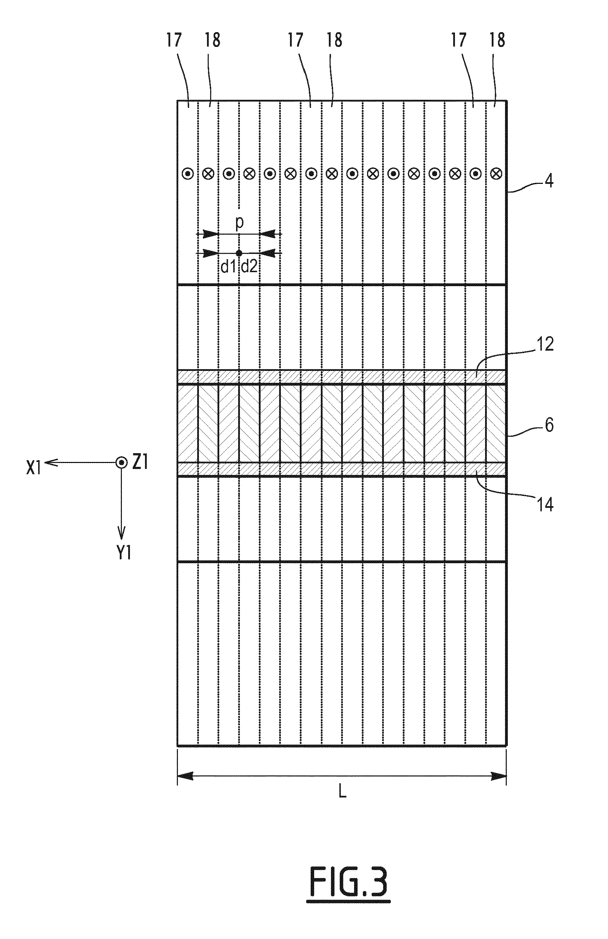

Ici, sur la Figure 1, seulement deux domaines ferroélectriques 17, 18 de polarisation opposée sont représentés tandis que sur la Figure 3 une séquence entière de domaines ferroélectriques à polarisation périodique est représentée.

Le domaine ferroélectrique 17 d'un premier type possède une polarité positive, c'est à dire est caractérisé par un vecteur de champ électrique dipolaire dirigé dans le sens de l'axe Z1 positif.

Le domaine ferroélectrique 18 d'un deuxième type possède une polarité négative, c'est-à-dire est caractérisé par un vecteur de champ électrique dipolaire dirigé dans le sens de l'axe Z1 négatif.

Les largeurs des domaines ferroélectriques 17 et 18 suivant l'axe X1 sont désignées respectivement par d1 et d2.

L'ensemble formé par le domaine de premier type 17 et le domaine de deuxième type 18, adjacent au premier domaine 17, forme un motif de répétition de l'agencement périodique des polarités des domaines 17 et 18.

La largeur du motif qui est la période spatiale de l'agencement périodique des polarités ferroélectriques est désignée par la grandeur p et est égale à la somme de la largeur d1 et de la largeur d2.

Le rapport entre la largeur d1 et la période p ou de manière correspondante le rapport entre la largeur d2 et la période p désigne le rapport cyclique du motif.

Ici, sur les Figures 1 et 3 on suppose que le rapport cyclique d1/p est égal à 0,5, c'est-à-dire que les largeurs d1 et d2 des domaines ferroélectriques sont égales.

En variante, les directions des polarisations ferroélectriques respectives des domaines ferroélectriques 17, 18 sont différentes de la direction de l'axe Z1.

Il est tiré parti de ce genre de polarisation locale pour fonctionnaliser ou rendre périodiques les propriétés électroacoustiques du matériau résultant de manière à fabriquer des dispositifs à ondes acoustiques excités par effet piézoélectrique par l'intermédiaire du matériau ferroélectrique sur n'importe quel type de substrat métallique ou surface métallisée grâce à une polarisation électrique locale.

Ici, le substrat métallique est réalisé par les deux électrodes métalliques 12 et 14.

De manière classique et générale, la couche de matériau piézoélectrique et ferroélectrique est réalisée à partir d'un matériau ferroélectrique quelconque, mono, poly ou multi-cristallin, par exemple de l'oxyde de plomb, titane, zirconium dénommé PZT, du niobate de lithium LiNbO₃, du tantalate de lithium LiTaO₃ ou bien encore du niobate de potassium KNbO₃.

L'épaisseur de la couche de la tranche brute (dénommé en anglais raw wafer) est classiquement comprise entre 10 µm et 1000 µm et est égal à la somme de l'épaisseur e1 du bloc de substrat 4 et de la largeur l de la plaque 6 de transduction piézoélectrique et ferroélectrique.

L'inversion des domaines ferroélectriques associée à la réalisation de microstructures périodiquement inversées peut être réalisée par la mise en oeuvre de différentes techniques.

Par exemple, pour fabriquer du niobate de lithium LiNbO₃ périodiquement inversé en termes de domaines ferroélectriques, les techniques suivantes peuvent être utilisées :
- la croissance du cristal de LiNbO₃ avec un dopant,
- l'exo-diffusion de Li₂O sur la face Z+,
- la diffusion de titane sur la face Z+,
- le bombardement électronique,
- l'application d'un champ électrique.

Ici, le matériau en niobate de litihium, pré polarisé ou non, dont la coupe cristallographique est notée par ZX selon le standard IEEE Std-176 Révision 1949, a été soumis localement au préalable sélectivement le long de l'axe X à un champ électrique important, dépassant le champ coercitif et dirigé selon l'axe Z, à l'aide d'une électrode métallique en forme de pointe ou d'apex, ou dont on a réalisé la géométrie en fonction du profil de polarisation locale souhaité.

Les axes cristallographiques X, Y, Z du deuxième matériau coïncident ici respectivement avec les axes X1, Y1, Z1 du trièdre de référence.

Des structures avec inversion des domaines de pas de l'ordre de quelques centaines de nanomètres peuvent ainsi être réalisées et sont tout à fait adaptées à des applications hautes fréquences. Le pas de réseaux p est de l'ordre de la longueur d'onde acoustique.

La fréquence f est obtenue en première approximation en divisant la vitesse de phase de l'onde, désignée par v_{ϕ}, par le pas de réseau p.

En alternant des domaines de polarisation positive et de polarisation négative on alterne extensions et compressions de matière au niveau de la couche de matériau ferroélectrique de manière à générer des interférences acoustiques constructives, se propageant préférentiellement dans le plan XY de la couche plutôt que dans le volume, la couche ayant une fonction de guide.

Il est alors possible de définir entre les deux électrodes de flanc 12 et 14 un unique transducteur piézoélectrique qui présente une admittance caractéristique bien identifiée.

Ce transducteur pourra être utilisé par la suite en combinaison d'autres transducteurs du même type (mais dont la fréquence centrale est différente) de façon à réaliser des filtres en réseaux ou en treillis, ou bien définir un transducteur d'entrée et un transducteur de sortie.

L'intérêt d'un tel transducteur piézoélectrique et ferroélectrique, polarisé périodiquement, réside dans le fait qu'il permet de fabriquer des composants à ondes élastiques guidées fonctionnant naturellement à des fréquences plus élevées que les composants classiques à ondes de surfaces (SAW pour Surface Acoustic Wave), et présentant une robustesse technologique supérieure à celle des dispositifs à peignes interdigités.

Suivant les Figures 1 à 3, la plaque de transduction piézoélectrique 6 et le bloc de substrat 4 forment une pièce unique d'un seul tenant.

Les première et deuxième électrodes métalliques 12, 14 recouvrent au moins en partie et respectivement la première face 8 et la deuxième face 10 de la plaque de transduction 6. Pour réaliser l'excitation des ondes élastiques guidées, les surfaces respectives de la première électrode et de la deuxième électrode se superposent au moins partiellement au travers de la plaque de transduction.

Il est à remarquer que l'idée sous-jacente qui a conduit à la conception du transducteur piézoélectrique de la Figure 1 est d'abord de réaliser une couche de substrat brut de transducteur à polarisation ferroélectrique périodique selon l'axe X sur une coupe ZX de niobate de lithium, de tantalate de lithium ou de tout matériau ferroélectrique permettant une polarisation distribuée sur tranche.

L'idée sous-jacente est ensuite d'amincir dans le sens de son épaisseur d'une manière ou d'une autre la couche de substrat brut de forme initiale globalement parallélépipédique et enveloppant la plaque de transduction piézoélectrique que l'on cherche à réaliser en final, de façon à réaliser un transducteur piézoélectrique et ferroélectrique sous la forme d'une plaque ou d'un barreau attaché perpendiculairement au bloc de substrat. Cette opération est rendue possible grâce à l'utilisation d'une scie à lame diamantée polissant les flancs des barreaux, leur conférant ainsi des capacités de guidage compatibles à l'application.

L'utilisation d'une lame capable de polir les faces en même temps que la découpe offre la possibilité de réaliser des faces compatibles avec l'excitation et le guidage d'ondes efficaces au sens de la qualité de la résonance. La surface résultante doit présenter une rugosité de quelques dizaines à quelques nanomètres en écart type RMS (en anglais Root Mean Square), idéalement un poli optique. En tout état de cause, une rugosité des surfaces en regard du résonateur supérieure à 100 nm RMS n'est pas compatible avec une qualité de la résonance conforme au standard de l'acousto-électricité.

L'idée sous-jacente consiste enfin à déposer des électrodes séparées sur les flancs de la tranche de plan d'extension ZX.

Dès lors, des ondes acoustiques peuvent être excitées électriquement, guidées et piégées dans la plaque de transduction à polarisation ferroélectrique alternée, la polarisation des ondes élastiques étant soit majoritairement longitudinale, soit majoritairement transverse. La plaque de transduction présente un couplage électroacoustique notablement élevé (jusqu'à 12% pour le mode longitudinal et supérieur à 20% pour le mode transverse) pour des configurations optimisées en termes de période p et de dimensions L, e2, l de la plaque de transduction, la structure formant la plaque de transduction étant dispersive et imposant la maîtrise de ses caractéristiques dimensionnelles.

La structure de la plaque de transduction doit être régulière en épaisseur e2 afin d'offrir des conditions de résonance optimales, en notant que la nature du mode et ses propriétés de dispersion dictent en premier lesdites conditions, soit la variation des propriétés spectrales du guide en fonction de ses caractéristiques géométriques.

Il est à remarquer que du point de vue du résonateur seul, e2 représente l'épaisseur du matériau selon laquelle la dispersion modale apparaît. L'épaisseur e2 pourrait être également considérée d'un point de vue structurel comme une largeur de la plaque à condition de considérer la dimension l de profondeur de la plaque comme une hauteur. L'augmentation de cette hauteur l a pour effet l'amélioration de la pureté spectrale et la minimisation de la largeur des raies correspondant aux contributions modales.

Pour le premier mode excité par la structure, de polarisation majoritairement longitudinale, la sensibilité de la fréquence de synchronisme à l'épaisseur du barreau ou de la plaque varie dans la région de plus fort couplage de quelques pour-cents de MHz par µm, alors que dans le cas du mode de cisaillement, cette sensibilité peut évoluer de plusieurs dizaines de pour-cents de MHz (voire plus de 100%) par µm.

La polarisation longitudinale est définie telle que la polarisation de la propagation acoustique soit colinéaire à la longueur L de la plaque, ou encore telle que l'onde acoustique présente une polarisation quasi-scalaire avec un déplacement dynamique normal au champ d'excitation électrique, le long de la périodicité ferroélectrique. La polarisation de cisaillement est définie telle que l'onde acoustique présente un champ quasi-scalaire avec un déplacement dynamique normal aux faces latérales de la plaque et distribué dans son épaisseur, la propagation étant toujours le long de la périodicité.

En conséquence, la maîtrise de l'épaisseur e2 de la plaque s'avère critique pour garantir une fréquence de travail parfaitement définie. En tout état de cause, une configuration préférée du transducteur correspond à une plaque d'épaisseur ne variant pas plus de 5% de la valeur nominale visée.

Ici, suivant les Figures 1 à 3, à titre d'exemple, la plaque de transduction a été découpée suivant une coupe notée YX selon le standard IEEE Std-176 Révision 1949 dans un substrat brut, prédécoupé suivant une coupe de niobate de lithium notée ZX. La découpe de la plaque résonnante a été effectuée en supposant que l'excitation électrique est appliquée entre les deux faces 10, 12 de la plaque et le sens de propagation des ondes de volume guidées est dirigée suivant la direction de répartition des domaines ferroélectriques, c'est-à-dire suivant le sens de la longueur L de la plaque de transduction.

L'épaisseur e2 et la largeur l de la plaque de transduction sont respectivement égales à 5µm et 25µm.

La coupe ZX du substrat brut est choisie d'une part pour sa disponibilité car c'est un standard pour le niobate de lithium et pour ses coupes orthogonales (YX) et (YXI)/180° correspondant aux domaines ferroélectriques alternés polarisés selon l'axe Z, particulièrement favorables pour des ondes de volume guidées selon l'axe X entre des faces planes, parallèles, distantes entre elles et ayant comme plan d'extension ZX.

La plaque de transduction ainsi usinée sur une coupe de niobate de lithium ZX formant substrat avec des domaines ferroélectriques polarisés selon l'axe Z équivaut donc à une configuration de transducteur à ondes guidées selon l'axe X dont la fréquence est égale au rapport de la vitesse de phase v_{ϕ} du mode de vibration sur le pas p.

Il est à remarquer que lorsque le facteur de forme de la plaque de transduction, désigné par FI et égal au rapport de la largeur de la plaque l sur la deuxième épaisseur e2, est de faible valeur, ici de l'ordre de 5, la structure considérée est pénalisée par un ou des modes parasites qui perturbent le mode de vibration des ondes guidées.

Afin d'améliorer cet état de fait plusieurs solutions existent.

Une première solution consiste à allonger la largeur l de la plaque pour favoriser l'établissement des modes guidées utiles entre les deux faces d'électrodes et minimiser la perte d'énergie acoustique au voisinage du bloc de substrat.

Cette solution s'avère très efficace et de meilleurs résultats, en termes d'une résonance du mode guidé très bien résolue et très pure en réponse spectrale, sont obtenus lorsque par exemple le facteur de forme FI est égal ou supérieur à 15, ce cas correspondant à une épaisseur e2 de 5 µm et une largeur l ou hauteur de 75 µm.

Lorsque le facteur de forme Fl est encore plus élevé, par exemple égal à 200, la pureté spectrale du transducteur est améliorée.

Ainsi, lorsque le facteur le facteur de forme FI est suffisamment élevé, le coefficient de qualité de la résonance n'est limité que par les propriétés intrinsèques du matériau constituant la plaque de transduction seule et non par les effets de perte par rayonnement acoustique dans le bloc de substrat.

De manière générale, le deuxième matériau constituant la plaque de transduction est compris dans l'ensemble des matériaux formé par l'oxyde plomb, le titane, le zirconium PZT, le tantalate de lithium LiTaO₃, le niobate de lithium LiNbO₃, le niobate de potassium, le PbTiO₃, et de façon générale les matériaux ferroélectriques de haute qualité cristalline, notamment les céramiques monocristallines) disponibles en plaque suffisamment épaisse pour permettre la mise en oeuvre technologique des barreaux ou plaque de transduction.

De manière générale, le premier matériau est compris dans l'ensemble des matériaux formé par le carbone-diamant, le silicium, le saphir, le carbure de silicium, le quartz, le niobate de lithium, le tantalate de lithium, le niobate de potassium, les céramiques piézoélectriques, le quartz, le tétraborate de lithium, l'orthophosphate, de gallium, le langasite, la langatate, le langanite, la silice et de façon générale les matériaux de qualité acoustique avérée permettant la mise en oeuvre de la structure.

De manière générale, la plaque de transduction est fixée perpendiculairement au voisinage de la face plane du bloc de substrat de sorte que la largeur de la plaque de la plaque de transduction et la première épaisseur du bloc de substrat ont un même sens.

De manière générale le premier matériau, le deuxième matériau, la première épaisseur e1 du bloc de substrat 4, la longueur L, la largeur l, la deuxième épaisseur e2 de la plaque de transduction 6 sont configurés pour créer et piéger des ondes de volume à la fréquence de fonctionnement du transducteur entre ses deux faces planes 8, 10, et pour créer un guide d'ondes acoustiques guidées se propageant dans le sens de la longueur L de plaque de transduction.

En fonctionnement, le résonateur est branché en sortie d'une source d'excitation électrique 20 et en entrée d'un circuit d'extraction 22 d'un signal utile à la fréquence de résonance et de travail f, le circuit d'extraction 22 formant une charge de sortie.

La source d'excitation électrique 20, branchée entre la première électrode 12 et la deuxième électrode 14, est configurée pour générer un signal de tension ayant une composante sinusoïdale dominante à la fréquence de travail f.

Le circuit d'extraction 22, branché également entre la première électrode 12 et la deuxième électrode 14, est configuré pour extraire un signal utile à la fréquence de travail f.

Suivant les Figures 1 à 3, la structure 2 a donc des métallisations disposées le long de l'axe Z suivant le plan ZX, l'axe de périodisation étant toujours selon X et la normale à la plaque étant maintenant Y. Les propriétés de ce type de structures peuvent être modélisées en utilisant un maillage simple mais en appliquant la définition des angles de coupe conforme à la situation du modèle : l'alternance de polarisation selon l'axe Z correspond à des coupes (YX) et (YXI)/180° qui réfèrent bien à un retournement de 90° de la plaque ZX (au lieu d'avoir deux domaines voisins définis respectivement avec les coupes (YXI)/90° et (YXI)/-90° dans le cas d'une excitation sur les faces en regard de la plaque de coupe ZX).

Dans le cas classique avec l'axe Z normal à la plaque de transduction développé depuis de nombreuses années, un mode longitudinal est obtenu se propageant à 6200 mètres par seconde avec un couplage relativement modeste (inférieur au %).

Dans le cas de l'invention de la Figure 1 avec l'axe Y normal à la plaque de transduction 6, nous obtenons deux modes principaux, le premier correspondant à un mode longitudinal avec une vitesse de 6300 mètres par seconde et comportant un couplage avoisinant la dizaine de %, un second mode de cisaillement se propageant à une vitesse de 19000 mètres par seconde notablement mieux couplée (une valeur proche de 23% est ainsi obtenue pour le coefficient de couplage dans la configuration la plus favorable au sens des propriétés de dispersion du guide).

En variante, il est également possible de réaliser une polarisation telle que l'axe de périodisation soit selon Y, l'axe X étant maintenant normal à la plaque de transduction. Les faces métallisées sont maintenant suivant le plan ZY. On obtient alors des conditions d'excitation des modes sensiblement différentes de celles décrites plus haut mais toujours avec un coefficient de couplage notablement plus élevé que dans le cas classique avec l'axe Z normal à la plaque de transduction.

Les propriétés dispersives de ces deux modes ont été étudiées pour trois périodes p arbitraires soit 10µm, 50 µm et 100 µm avec un rapport cyclique de polarisation d1/p de 50%.

Quelle que soit la période du transducteur, l'évolution du couplage électromécanique est identique. Ensuite la dispersion en fréquence des modes est d'autant plus élevée que la période est petite (par exemple pour le mot longitudinal, une dispersion de 250 MH_{Z} est observée pour une période de 10µm et seulement de 25 MHz pour une période de 100 µm.

Le mode longitudinal est plus stable en fréquence (un facteur 5 pour une même période) mais moins couplé que le mode de cisaillement (jusqu'à 23% pour le mode de cisaillement et 12% pour le mode longitudinal).

L'évolution du couplage n'est pas linéaire et présente des maximums aux locaux du fait d'un phénomène de recouvrement avec d'autres modes venant croiser le mode suivi. Ainsi des points optimums de couplage électromécanique sont mis en évidence ainsi que des zones de travail où la fréquence est quasi stable de telle sorte à favoriser quelques dimensions (largeur du barreau et période de transducteur pour la fabrication des barreaux.

L'influence de la longueur L de la plaque sur la réponse acoustique de la plaque a été étudiée pour une période p du transducteur égale 50 µm, une largeur l du barreau de 90 µm et une épaisseur e2 de 24 µm. Cette caractérisation met en évidence l'excitation de nombreux modes à des fréquences avoisinant la centaine de mégahertz. En outre, plus la longueur L de la plaque est grande, plus la réponse acoustique est ample. En effet, la longueur L de la plaque joue sur le nombre de périodes excitées du transducteur. Dans ce cas, la période p du transducteur étant de 50 µm, une longueur L du transducteur supérieure à 300 longueurs d'ondes est à privilégier.

L'influence de la largeur l de la plaque sur la réponse acoustique a été étudiée pour une configuration de la plaque de transduction dans laquelle la période p du transducteur est égale à 10 µm, l'épaisseur e2 de la plaque est égale à 15 µm, la longueur L de la plaque est égale à 500 longueurs d'ondes. Plusieurs modes excités dans une bande de fréquence de 300 MH_{Z} à 1,4 GH_{Z} sont à distinguer. Quelle que soit la largeur l de la plaque, la position fréquentielle des modes est identique. De surcroît le signal obtenu est mieux résolu quand la largeur de l de la plaque vaut 250 µm.

En effet, dans le cas d'une plaque de transduction à domaines ferroélectriques alternés, la largeur de la plaque peut être liée à l'ouverture acoustique du dispositif. Ainsi, plus l'ouverture acoustique est faible, plus la réponse sera atténuée. D'après diverses expériences et d'après les écrits de Royer et Dieulesaint dans les « Ondes élastiques dans les solides » (Masson Ed. 1997), à partir d'une centaine de longueurs d'ondes, le signal serait optimum.

En pratique, dans le cas de la plaque, il est difficile de respecter cette grandeur de largeur optimale lorsque les substrats vendus ont une épaisseur de 500 µm au plus. En effet, si une période de 10 µm est considérée, il faudrait une profondeur de découpe de 1000 µm pour respecter les 100 λ.

Ainsi, dans les différents cas proposés, les réponses des dispositifs n'auront pas une résolution optimale mais des dispositifs peuvent toutefois être créés avec une largeur avoisinant les 250 µm, pour lesquels des performances intéressantes sont obtenues.

Il va de soi que plus les substrats vendus dans le commerce auront une épaisseur grande, plus grandes seront les largeurs l de plaque atteignables et plus favorable sera l'obtention d'un signal de résolution optimale.

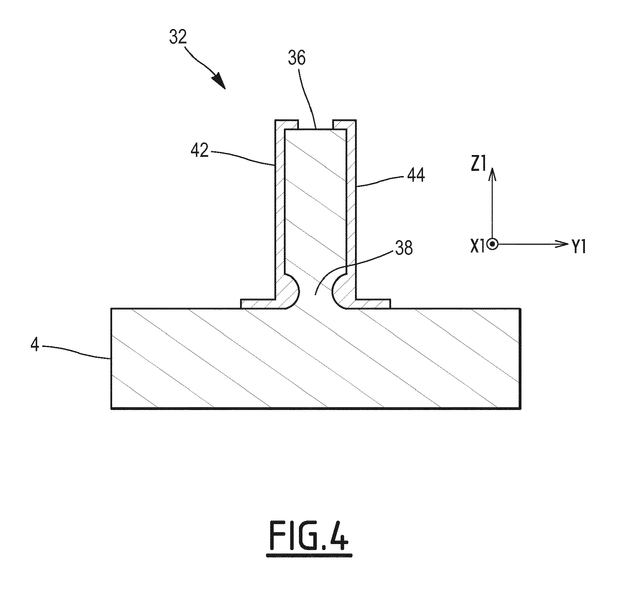

Suivant la Figure 4, un deuxième mode de réalisation de transducteur piézoélectrique 32 à polarisation ferroélectrique alternée, dérivé du résonateur 2 de la Figure 1 comprend une plaque de transduction 36, fixée d'un seul tenant au bloc de substrat 4.

Les matériaux utilisés et les dimensions géométriques de la plaque de transduction 36 et du bloc de substrat 4 en termes d'épaisseur e2, de longueur L et de largeur l sont identiques à ceux du transducteur 2 de la Figure 1.

La plaque de transduction 36 présente une zone d'étranglement 38 en épaisseur de plaque dans le sens de la largeur l sur toute sa longueur L.

Dans la zone d'étranglement 38, située au voisinage de la face plane 16 du bloc de substrat 4, l'épaisseur de la plaque de transduction 36 varie et passe par un minimum.

L'amincissement de la plaque de transduction 36 formé par la zone d'étranglement 38, utilisé à la base de la plaque de transduction 36, permet d'isoler au mieux la zone de vibration maximale des ondes guidées le long des faces ou flancs de la plaque de transduction 36 encastrée dans le bloc de substrat 4.

Dans ce mode de réalisation, cette structure est dénommée structure à bottle-neck ou à goulot d'étranglement par analogie avec la forme resserrée d'un goulot de bouteille.

Cette structure a été validée pour un facteur de forme FI de 15 comme envisagé pour le transducteur piézoélectrique de la Figure 1, c'est-à-dire une largeur l de la plaque de 75 µm pour une épaisseur e2 de 5 µm pour une configuration de transducteur optimale en couplage.

Des première et deuxième électrodes 42, 44 recouvrent chacune une face différente de flanc de la plaque 36 et remplissent au pied de la plaque la dépression formée par la zone d'étranglement de la plaque.

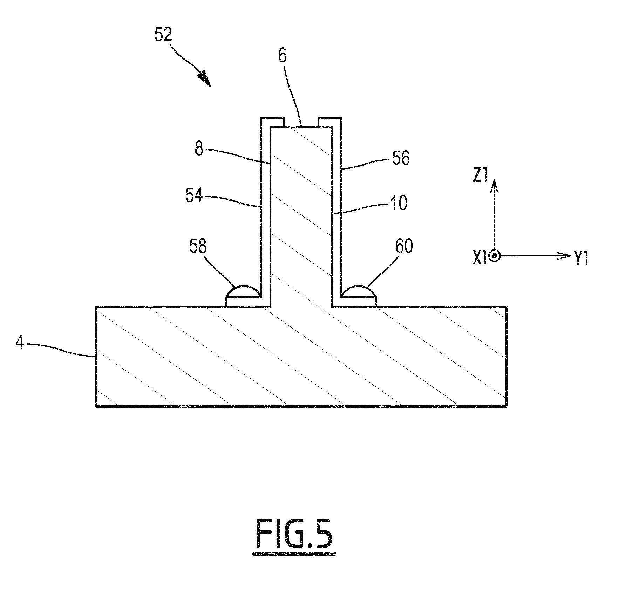

Suivant la Figure 5, un troisième mode de réalisation de transducteur piézoélectrique 52 à polarisation ferroélectrique périodique, dérivé du transducteur 2 de la Figure 1, met en oeuvre une métallisation accrue au niveau des électrodes sur la partie haute du substrat.

Dans ce mode de réalisation, seules les première et deuxième électrodes, désignées par les références numériques 54 et 56, diffèrent des électrodes 12 et 14 du transducteur piézoélectrique 2 de la Figure 1 en ce qu'elles comprennent chacune un bourrelet différent 58, 60, c'est à dire un supplément de métal.

Les électrodes 54, 56 sont configurées au travers de cet ajout de métal pour obtenir un effet de masse sur la partie haute du substrat et localiser le maximum de l'amplitude de la vibration acoustique loin de l'encastrement de la plaque 6 au substrat 4.

En variante cet effet de masse peut également être obtenu par dopage de la partie haute du substrat. Pour la plupart des matériaux monocristallins, il existe des méthodes de dopage permettant de substituer voire d'intégrer au sein de la maille des atomes étrangers à la structure cristalline pour moduler localement les propriétés de la matière.

Une méthode particulièrement utilisée en optique avec le niobate de lithium concerne l'échange protonique, décrit par exemple dans l'article de Toshiaki Suhara, Shuji Fujiwara, « Proton-exchanged Fresnel lenses in TILiNbO3 waveguides », Applied Optics, Vol. 25, Issue 19, pp. 3379-3383 (1986), qui permet la diffusion d'atomes légers (hydrogène, titane, etc.) au sein du réseau cristallin avec ou sans modifications structurelle.

On peut également substituer des atomes plus lourds (Erbium, MgO, etc.) au sein de la maille cristalline par diffusion à haute température comme décrit par Arnaud Grisard dans la thèse de l'université de Nice-Sophia Antipolis, U.F.R. Faculté des Sciences, 1997 intitulée « Laser Guides d'ondes dans le niobate de lithium dopé en Erbium ». Il est ainsi possible de modifier localement les propriétés élastiques du matériau par modification de la densité de masse et ainsi créer les conditions de guidage requises en fonction de l'orientation cristalline choisie.

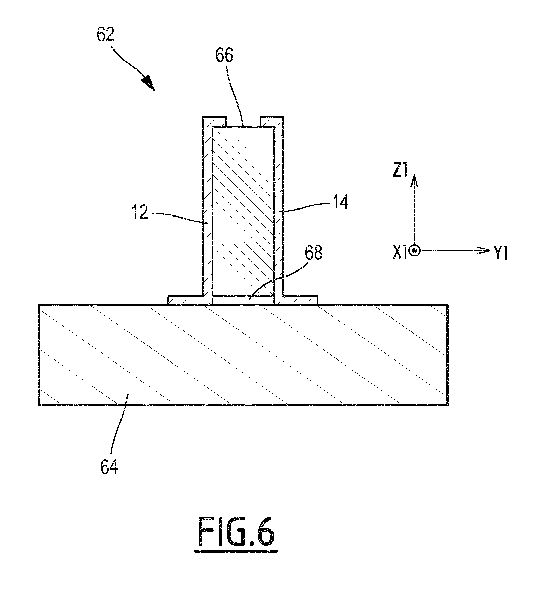

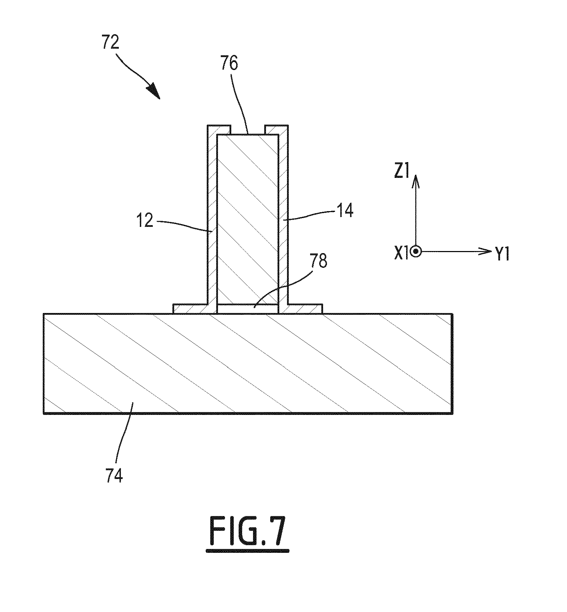

Suivant les Figures 6 et 7, d'autres structures de transducteurs piézoélectriques à polarisation ferroélectrique périodique permettent d'améliorer le piégeage de l'onde guidée le long et dans la plaque de transduction.

Suivant la Figure 6, une quatrième forme de réalisation de transducteur piézoélectrique 62 à polarisation ferroélectrique alternée comprend un bloc de substrat 64 et une plaque de transduction piézoélectrique 66 dont les matériaux sont différents.

Le matériau de la plaque de transduction 66 possède des propriétés piézoélectriques et comprend des domaines ferroélectriques dont les polarisations sont alternées.

La forme et les dimensions géométriques du bloc de substrat 64 et de la plaque de transduction 66 sont identiques à celles du bloc de substrat 4 et de la plaque de transduction 6 de la Figure 1.

Suivant la Figure 6, le bloc de substrat 64 et la plaque de transduction 66 sont des pièces distinctes reliées entre elles par un élément de liaison 68 comme ici un joint de colle transparent acoustiquement.

Un joint de colle peut être compris comme une couche polymère, déposée par exemple par centrifugation, et réticulée pour créer une liaison solide entre le matériau de la plaque et le matériau du bloc de substrat, ou encore des couches métalliques déposées sur les faces à coller et utilisées pour une report par diffusion inter-métallique, Au, In, Cu étant les matériaux les plus utilisés à cette fin, dans la mesure où ces couches ne viennent pas court-circuiter les électrodes en regard, déposées sur les faces de flanc de la plaque de transduction, ou encore des couches de silice déposées sur les faces à coller et activées de sorte que leur caractère hydrophile permette un collage moléculaire identique ou analogue à celui mis en oeuvre pour les substrats dits de SOI (Silico-On-Insulator, TM SOITEC), ou encore une liaison dite de « glass-frit » consistant au frittage d'une pâte chargée en silice donnant lieu à une liaison rigide de haute qualité structurelle.

Le premier matériau du bloc de substrat 64 est choisi de sorte que les vitesses de propagation des ondes de volume s'y propageant sont supérieures à celles du deuxième matériau.

Par exemple, le deuxième matériau constituant la plaque de transduction 66 est choisi en fonction de la nature du premier matériau parmi du niobate ou du tantalate de lithium, du quartz, de la langasite ou tout autre matériau piézoélectrique monocristallin, déposé sur une couche de carbone de diamant, ou le cas échéant plus simplement sur du silicium ou du saphir constituant le premier matériau du bloc de substrat.

Suivant la Figure 7, un cinquième mode de réalisation de transducteur 72, dérivé du transducteur de la Figure 6, comprend un bloc de substrat 74 et une plaque de transduction 76 dont les matériaux sont identiques.

Le transducteur 72 comprend un élément d'isolement acoustique 78, disposé entre le bloc de substrat 74 et la plaque de transduction 76, et fixé à ces derniers par deux joints de colle non représentés sur la Figure 6.

L'élément d'isolement acoustique 78 est ici un miroir de Bragg, réalisé ici par un empilement de couches d'impédances acoustiques très contrastées.

Les couches d'impédances acoustiques très contrastées sont par exemple des couches de nitrure d'aluminium ou de nitrure de silicium et d'oxyde de silicium, l'empilement étant configuré pour réfléchir en phase et complètement les ondes de volume aux fréquences de travail envisagées.

En variante, le premier matériau constituant le substrat et le deuxième matériau constituant la plaque sont différents.

Les modes de réalisation des Figures 6 et 7 peuvent être généralisés en considérant que le transducteur comprend un élément de fixation et/ou d'isolation acoustique, distinct du bloc de substrat et de la plaque de transduction, constitué en au moins un troisième matériau distinct des premier et deuxième matériau, l'élément de fixation et/ou d'isolation acoustique étant compris dans l'ensemble constitué par une unique couche de colle, un miroir de Bragg formé d'un empilement de couches à impédances acoustiques contrastées.

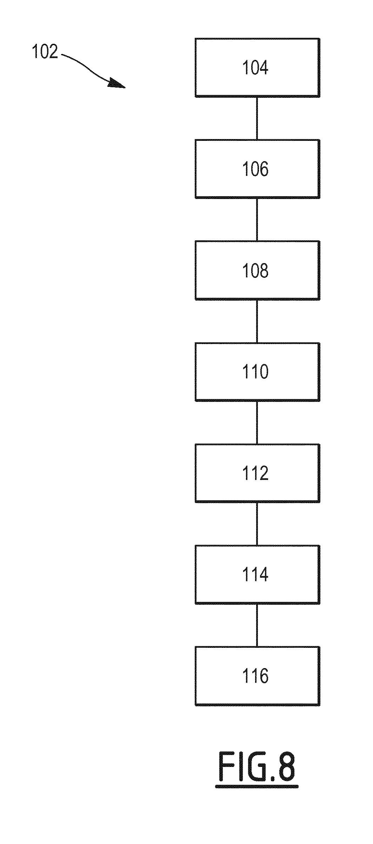

Suivant la Figure 8, un procédé 102 complet de réalisation d'un transducteur de la Figure 1, comportant au moins une plaque de transduction reliée d'un seul tenant et montée perpendiculairement sur un bloc de substrat, comprend une série d'étapes 104, 106, 108, 110, 112, 114, 116.

Les étapes de micro-fabrication sont applicables pour n'importe quelle coupe de niobate de lithium ou de tantalate de lithium.

Ici le matériau brut de départ du procédé est une tranche brute de niobate de litihium dénommée en anglais « wafer » dans laquelle des domaines ferroélectriques à polarisation alternée ont été créés selon un motif périodique.

De manière générale, sous couvert de déterminer les conditions de sciage appropriées, le procédé est applicable à tout matériau monocristallin piézoélectrique et ferroélectrique qui été polarisé électriquement de manière périodique.

L'utilisation d'une scie de précision, par exemple une scie de marque Disco ® qui permet en deux traits de scie de définir les deux plans des faces de la plaque résonante.

La machine utilisée pour le découpage de plaques de transduction à domaines ferroélectriques alternées est par exemple une scie de précision DISCO ® DAD 321, la référence des lames utilisées est DPAN 0781, les références techniques correspondent à la référence P1 A 863 BR10/ 56x0.2x40.

La résolution en épaisseur e2 d'une plaque de transduction piézoélectrique est définie par la précision d'alignement entre les deux traits de scie et peut atteindre 1 µm dans le meilleur des cas.

La largeur l de la plaque de transduction est définie, quant à elle, par la profondeur de coupe demandée dans la tranche brute de niobate de lithium suivant le sens de l'épaisseur du bloc du substrat qui sera réalisé en final. Cette largeur l peut atteindre plusieurs centaines de µm.

Dans une opération de sciage, la séquence des étapes suivantes est par exemple mise en oeuvre :
- utilisation d'une lame neuve préconisée pour une qualité de poli optimale,
- dressage de la lame consistant à centrer la lame après l'avoir physiquement placée sur le support de la machine, ainsi qu'à aiguiser les grains abrasifs de la lame lors de la réalisation des traits de découpe,
- découper des faces d'entrée et de sortie de plaques sur toute l'épaisseur du dispositif,
- réaliser des plaques ou barreaux.

Les conditions de découpe des plaques sont par exemple les suivantes :
- découpe complète des faces d'entrées et de sorties des futures plaques en considérant les paramètres de découpe suivants : vitesse d'avance égale à 0,18mm.s-1, vitesse de rotation du disque abrasif égale à 9000 tours par minute, découpe sur la larguer totale ;
- réalisation des plaques avec une vitesse d'avance égale à 0,18mm.s-1, une vitesse de rotation du disque abrasif égale à 9000 tours par minute, une découpe sur la largeur visée comme étant une épaisseur de la tranche brute (wafer) de substrat.

L'épaisseur et la longueur des plaques peuvent varier à volonté, la qualité de l'état de surface des flancs des plaques étant réputée comme étant un poli optique.

Dans une première étape 104, une tranche brute de niobate de litihium est fournie dont la coupe de départ est notée ZX dans le sens de l'épaisseur avec une première face supérieure et une deuxième face inférieure. La tranche brute qui possède des propriétés piézoélectriques et ferroélectriques comprend des premiers domaines de polarisation positive selon l'axe orienté Z et des seconds domaines de polarisation négative, c'est à dire de sens inverse à l'axe Z, les premiers domaines et les seconds domaines étant répartis dans le sens de l'axe X en étant alternés selon un motif de répétition, le motif de répétition étant défini par un pas p et un rapport cyclique.

Dans une deuxième étape 106, la face supérieure de la tranche de niobate de lithium ayant pour normale l'axe Z est enduite d'une résine, par exemple de la résine S 1828 de marque Shipley. Le dépôt de la résine est effectuée par exemple par un procédé de type Revêtement par Rotation Centrifuge (en anglais spin coating) sur une épaisseur de 2,5 µm. Dans la même étape 106, la résine est recuite en étuve pendant une heure à 95° Celsius afin d'évaporer les solvants et de la rendre ainsi plus résistante à l'étape de découpe par la scie.

Dans une troisième étape 108, une plaque ou plusieurs plaques de transduction sont découpées suivant un plan de coupe ZX. Pour configurer le sciage d'une plaque de transduction, ici quatre traits de scie sont requis au moins afin de réaliser la plaque. En effet, la largeur de la lame de la scie étant de 200 µm, deux traits de scie superposés sont réalisés afin d'obtenir un espace accessible de 350-400 µm de part et d'autre de la plaque pour permettre des tests sous pointes.

Lors de la troisième étape 108, l'épaisseur e2 et la largeur l d'au moins une plaque de transduction sont définies par la profondeur des découpes et la précision d'alignement entre les séries de deux traits de scie ainsi que la largeur des électrodes par la superposition de deux traits de scie.

Une fois la troisième étape 108 réalisée, dans une quatrième étape 110 au moins une bande dans le sens de la longueur sur chaque face libre de sommet des plaques ainsi que des bandes dans le sens de la longueur sur des faces de plancher du substrat situées entre des plaques sont recouverts par la résine de protection S 1828.

Dans une cinquième étape 112, des électrodes métalliques sont déposées sur les faces latérales, c'est-à-dire les flancs des plaques, ainsi qu'au fond des tranchées de largeur comprise entre 350-400 µm sur une longueur L pouvant atteindre plusieurs centimètres.

Afin de recouvrir les flancs d'une plaque ou d'une série de plaques formant un créneau sur une largeur l pouvant atteindre plusieurs centaines de µm, un dépôt d'aluminium est réalisé par pulvérisation cathodique en trois fois en basculant la puce, formée par le substrat et les plaques, par exemple deux fois de 45° autour d'un axe orienté dans le sens de la longueur L des plaques.

Dans cette cinquième étape 112, la puce entière est recouverte par la couche d'aluminium et les électrodes sont alors obtenues par la technique dite du lift-off. Pour cela, la puce est plongée dans un bain de solvant (en anglais remover), par exemple le remover 1165, solution chimique dissolvant la résine de protection, ici la résine S 1828, chauffé à 70° pendant plusieurs heures.

Le lift-off est ensuite accéléré et achevé par l'utilisation d'un bain à ultra-sons pendant une minute.

Ensuite dans une sixième étape 114, afin de solidifier les plaques ou barreaux avant une septième étape 116 de découpe longitudinale des plaques de transduction, les plaques ou barreaux de transduction piézoélectriques sont enduits d'une résine de protection S1805 à l'aide de la technique de revêtement par pulvérisation, dénommée en anglais spray-coating. Cette sixième étape 114 permet de recouvrir de résine, les tranches de niobate structurées, c'est-à-dire dire les puces munies de leurs électrodes.

La septième et dernière étape 116 consiste à définir la longueur L des plaques ou barreaux par découpe à la scie, par exemple ici dans notre cas une longueur L de 500 µm. Cette septième étape 116 est assez critique et peut entraîner la casse donc la perte de nombreuse plaques. En effet, il s'agit ici de faire des traits de scie perpendiculaires à une surface crènelée tous les 500 µm suivant le sens de la longueur L et sur une profondeur supérieure à la première profondeur de découpe, c'est-à-dire la largeur l des plaques, afin de rendre électriquement indépendante chaque puce élémentaire ainsi formée.

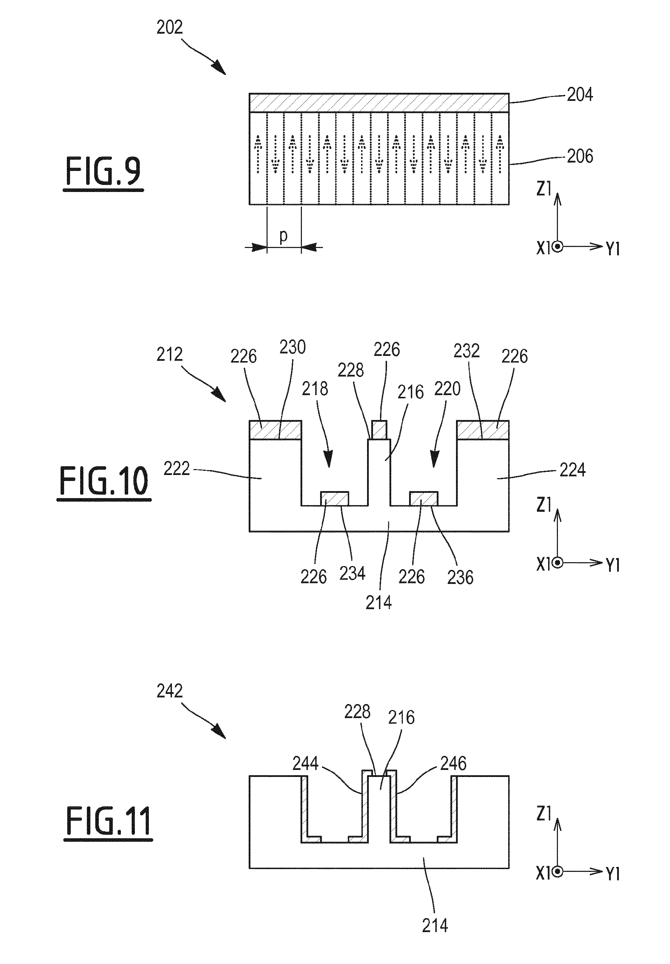

Suivant la Figure 9, un premier état intermédiaire 202 du transducteur 2 de la Figure 1, obtenu à la fin de la deuxième étape 106 du procédé 102, est un empilement d'une couche 204 de résine S1828 et d'une tranche brute 206 de niobate de lithium.

La tranche brute 206 possède des propriétés piézoélectriques et ferroélectriques et comprend des premiers domaines de polarisation positive selon l'axe orienté Z et des seconds domaines de polarisation négative, c'est à dire de sens inverse à l'axe Z, les premiers domaines et les seconds domaines étant répartis dans le sens de l'axe X en étant alternés selon un motif de répétition, le motif de répétition étant défini par deux domaines ferroélectriques adjacents de polarisation différente, un pas p et un rapport cyclique.

Suivant la Figure 10, un deuxième état intermédiaire 212 du transducteur 2 de la Figure 1 fabriqué par le procédé 102, obtenu à la fin de la troisième étape de sciage 108 comprend un bloc de substrat dans lequel a été usinée verticalement sur la Figure 10 une plaque 216, entourée de part et d'autre d'un creux ou d'une vallée nue 218, 220, c'est-à-dire exposée. Deux barres 222, 224 d'extrémité du bloc 214 entourent la plaque de transduction 216 qui est ici unique. Une couche de résine 226 est déposée sur une face de sommet 228 de la plaque et sur des faces de sommet 230, 232 des barres 222, 224 ainsi que sur deux bandes de creux 234, 236 disposées de part et d'autre de la plaque 216.

Suivant la Figure 11, un troisième état intermédiaire 242 du transducteur 2 de la Figure 1 fabriqué par le procédé 102, obtenu à la fin de l'étape de lift-off 112 de dépôt des électrodes est une puce structurée.

Ici, la puce 242 comprend une seule plaque de transduction 216 avec deux électrodes 244, 246 en aluminium de part et d'autre de ses deux flancs, chaque électrode 244, 246 venant déborder légèrement sur la face de sommet 228 de la plaque 216 et sur une partie de la face de plancher du substrat 214 au pied de chaque flanc de la plaque de transduction 216.

Cette structure après découpage des bords du substrat correspond à la structure du transducteur 2 de la Figure 1.

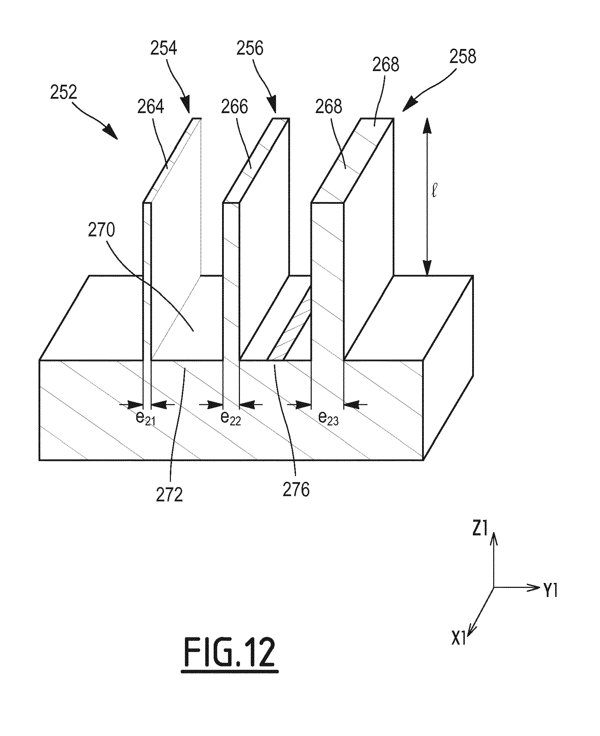

Suivant la Figure 12, une puce 252 formant un circuit complexe résonant, comprend trois transducteurs élémentaires 254, 256, 258 du type de celui de la Figure 1 formés chacun par une plaque de transduction différente 264, 266, 268. Chaque plaque de transduction 264, 266, 268 de même largeur l présente une épaisseur différente e21, e22, e23.

Les deux premières plaques de transduction 264, 266, représentées à gauche sur la Figure 11, sont couplées entre elles par la mise en commun d'une même électrode 270, réalisée par une liaison métallique déposée sur un plancher 272 de substrat commun.

Les deux premières plaques de transduction 264, 266 sont séparées électriquement de la troisième plaque 268 par une bande isolante 276.

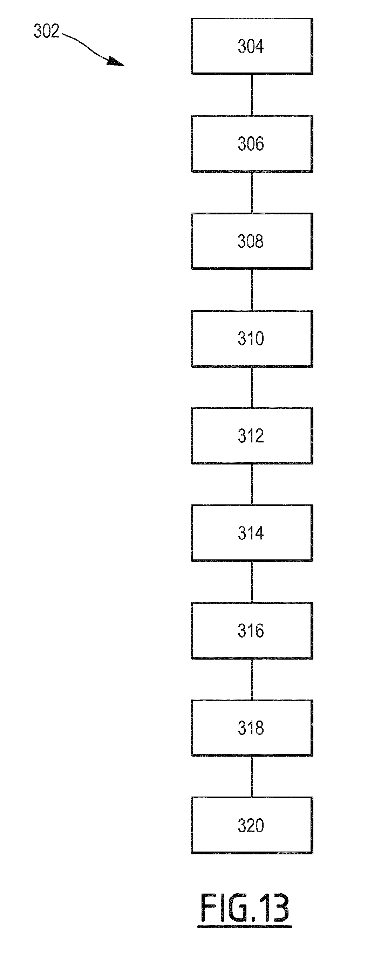

Suivant la Figure 13, un procédé 302 complet de réalisation d'un transducteur de la Figure 6 ou la Figure 7, comportant au moins une plaque de transduction piézoélectrique à polarisation ferroélectrique périodique, reliée au travers d'un moyen de fixation et/ou d'isolation acoustique en étant monté perpendiculairement sur un bloc de substrat, comprend une série d'étapes 304, 306, 308, 310, 312, 314, 316, 318, 320.

Ici, le moyen de fixation et/ou d'isolation acoustique est un miroir de Bragg, disposé entre la plaque et barreau et le substrat. Le miroir de Bragg est réalisé ici par un empilement de couches d'impédances acoustiques très contrastées, des couches de nitrure d'aluminium ou de nitrure de silicium et d'oxyde de silicium par exemple, l'empilement étant configuré pour réfléchir en phase et complètement les ondes de volume aux fréquences de travail envisagées.

Dans une première étape 304, une première tranche de niobate de lithium est fournie dont la coupe de départ est notée ZX dans le sens de l'épaisseur avec une première face supérieure et une deuxième face inférieure. La tranche brute qui possède des propriétés piézoélectriques et ferroélectriques comprend des premiers domaines de polarisation positive et des seconds domaines de polarisation négative, les premiers domaines et les seconds domaines étant répartis dans le sens de l'axe X en étant alternés selon un motif de répétition, le motif de répétition étant défini par un pas p et un rapport cyclique.

Dans une deuxième étape 306, un miroir de Bragg est disposé sur la face supérieure du substrat de niobate de lithium, la surface du miroir ayant une envergure suffisante pour isoler un nombre important de plaques résonantes.

Le miroir est réalisé ici par un empilement de couches d'impédances acoustiques très contrastée et de large étendue, des couches de nitrure d'aluminium ou de nitrure de silicium et d'oxyde de silicium par exemple, l'empilement étant configuré pour réfléchir en phase et complètement les ondes de volume aux fréquences de travail envisagées.

Le miroir de Bragg est fixé au substrat par un procédé de collage avec le dépôt au préalable d'un joint de colle.

Ce miroir est alors constitué d'un empilement de matériaux reportés selon des procédés énoncés ci-dessus (collage polymère, diffusion métallique, collage moléculaire) et amincis pour atteindre les épaisseurs requises, qui peuvent varier notablement en fonction des fréquences de travail visées.

Plus particulièrement pour des applications radiofréquences, les épaisseurs de couches requises peuvent s'avérer compatibles des méthodes de dépôts assistées plasma, physiques ou chimiques, en phases solides ou vapeurs (évaporation, pulvérisation cathodique, dépôt sous phases vapeurs chimiques, jets moléculaires, etc.), donnant lieu à des empilements de couches quelques micromètres à une fraction de µm d'épaisseur chacune. Il est ainsi loisible de réaliser des couches multiples présentant des épaisseurs maîtrisées et donnant lieu à un miroir de grande efficacité de réflexion, proche de celle d'une lame d'air.

Dans une troisième étape 308, une couche d'un transducteur piézoélectrique est déposée sur le miroir de Bragg. La couche de transduction est une deuxième tranche brute de niobate de lithium dont la coupe de départ est notée ZX dans le sens de l'épaisseur avec une première face supérieure et une deuxième face inférieure. A l'instar de la première tranche brute, la deuxième tranche brute possède les mêmes propriétés piézoélectriques et ferroélectriques et comprend des premiers domaines de polarisation positive et des seconds domaines de polarisation négative, les premiers domaines et les seconds domaines étant répartis dans le sens de l'axe X en étant alternés selon un motif de répétition, le motif de répétition étant défini par un pas p et un rapport cyclique.

L'orientation cristallographique du matériau du transducteur piézoélectrique et la configuration de ses domaines ferroélectriques sont choisies de sorte que lorsque la couche de transduction est découpée selon le sens de l'épaisseur du substrat par deux plans parallèles entre eux et de direction normale Y, le coefficient de couplage électroacoustique est élevé et la configuration est favorable à la création et au piégeage d'ondes élastiques de volume à la fréquence de fonctionnement du transducteur guidées entre deux faces planes ZX et se propageant dans le sens de l'axe X qui sera l'orientation choisi pour la longueur de la plaque de transduction.

Ici, on suppose que le matériau de la couche de transduction est le même que le matériau du substrat, c'est-à-dire en niobate de lithium avec la même configuration implanté des domaines ferroélectriques.

Cela permet d'utiliser un même wafer de départ qui est coupé en deux parties égales, une première partie servant de couche de substrat, et une deuxième partie servant de couche de transduction.

Toutefois, en variante le matériau de substrat peut être différent de celui de la couche de transduction sous réserve de conserver les mêmes caractéristiques décrites ci-dessus pour la couche de transduction. En d'autres termes, la couche de transduction est nécessairement formée d'un matériau piézoélectrique et ferroélectrique dans lequel sont implantés des domaines ferroélectriques à polarisation alternée, à l'inverse de la couche de substrat qui peut être dépourvue de domaines ferroélectrique et même ne pas être constitué en un matériau ferroélectrique.

La fixation de la couche de transduction sur le miroir de Bragg est réalisé à l'aide d'un joint de colle par exemple.

Dans une quatrième étape 310, analogue à la deuxième étape 106 du procédé 102, la face supérieure de la tranche de niobate de lithium formant le transducteur est enduite d'une résine, par exemple de la résine S 1828 de marque Shipley. Le dépôt de la résine est effectué par exemple par un procédé de type Revêtement par Rotation Centrifuge (en anglais spin coating) sur une épaisseur de 2,5 µm. Dans la même étape la résine est recuite en étuve pendant une heure à 95° Celsius afin d'évaporer les solvants et de la rendre ainsi plus résistante à l'étape de découpe par la scie.

Dans une cinquième étape 312, analogue à la troisième étape 108 du procédé 102, une plaque ou plusieurs plaques de transduction sont découpées dans l'empilement suivant des plans parallèles de direction ZX.

Pour configurer le sciage d'une plaque résonnante, ici quatre traits de scie sont requis au moins afin de réaliser la plaque. En effet, la largeur de la lame de la scie étant de 200 µm, deux traits de scie superposés sont réalisés afin d'obtenir un espace accessible de 350-400 µm de part et d'autre de la plaque pour permettre des tests sous pointes.

Lors de la cinquième étape 312, l'épaisseur e2 et la largeur l d'au moins une plaque sont définies par la profondeur des découpes et la précision d'alignement entre les séries de deux traits de scie ainsi que la largeur des électrodes par la superposition de deux traits de scie.

Une fois la cinquième étape 312 réalisée, une sixième étape 314, identique à la quatrième étape 110 du procédé 102 est réalisée.

Dans une septième étape 316, identique à la cinquième étape 112 du procédé 102, des électrodes métalliques sont déposées.

Ensuite dans une huitième étape 318, les plaques ou barreaux de transduction sont enduits d'une résine de protection S1805 à l'aide de la technique de revêtement par pulvérisation (dénommée en anglais spray-coating). Cette huitième étape permet de recouvrir de résine, les tranches de niobate structurées, c'est-à-dire dire les puces munies de leurs électrodes.

La neuvième et dernière étape 320 consiste à définir la longueur L des plaques ou barreaux par découpe à la scie, par exemple ici dans notre cas un longueur L de 500 µm.

Suivant la Figure 13, un premier état intermédiaire 322 du transducteur de la Figure 7, obtenu à la fin de la deuxième étape 306 du procédé 302, est un empilement d'une première tranche brute 324 de niobate de lithium à polarisation ferroélectrique alternée destinée à former le substrat porteur, d'une couche 326 formant un miroir de Bragg enserré dans deux joints de colle, d'une deuxième tranche brute 328 de niobate de lithium à polarisation ferroélectrique alternée destinée à former au moins une plaque de transduction après usinage, et une couche 330 de résine S1828.

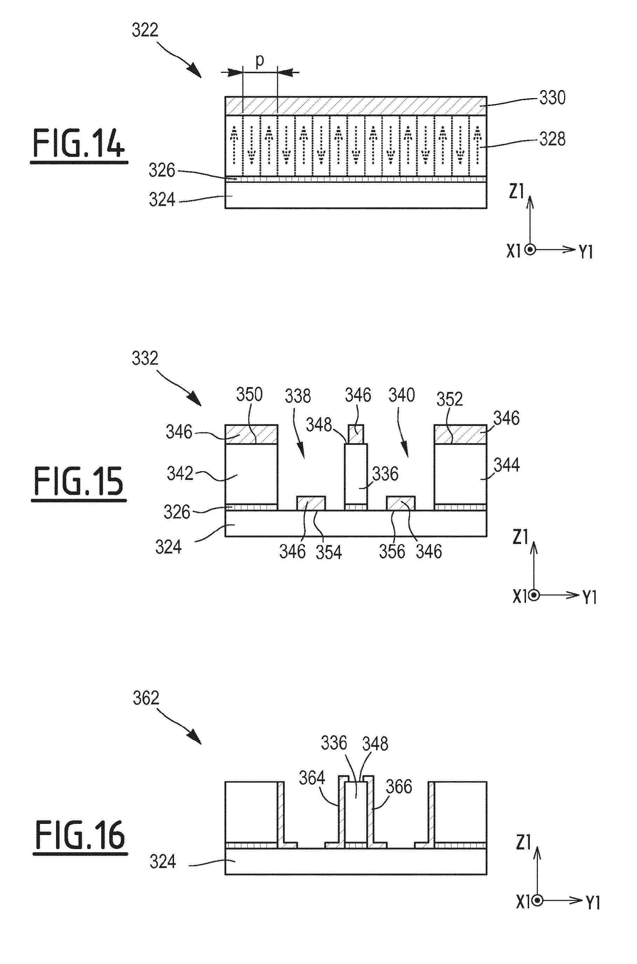

Suivant la Figure 15, un deuxième état intermédiaire 332 du transducteur de la Figure 7, obtenu à la fin de la troisième étape de sciage 308, comprend le bloc de substrat 324, une plaque de transduction 336 usinée dans l'ensemble des couches 326, 328, 330, entourée de part et d'autre d'un creux ou d'une vallée nue 338, 340, c'est-à-dire exposée. Deux barres 342, 344 d'extrémité de la puce 332 entourent la plaque de transduction 336 qui ici est unique. Une couche de résine 346 est déposée sur une face de sommet 348 de la plaque 336 et sur des faces de sommet 350, 352 des barres 342, 344 ainsi que sur deux bandes de creux 354, 356 disposées de part et d'autre de la plaque 336.

Suivant la Figure 16, un troisième état intermédiaire 362 du transducteur de la Figure 7, obtenu à la fin de l'étape de lift-off de dépôt des électrodes, est une puce structurée.

Ici, la puce 362 comprend une seule plaque de transduction 336 avec deux électrodes 364, 366 en aluminium de part et d'autre de ses deux flancs, chaque électrode 364, 366 venant déborder légèrement sur la face de sommet 348 de la plaque 336 et sur une partie de la face de plancher du substrat 324 au pied de chaque flanc de la plaque de transduction 336.

Cette structure après découpage des bords du substrat correspond à la structure du transducteur de la Figure 7.

De manière générale, un procédé de fabrication 402 d'un transducteur décrit dans les Figures 1 à 7 comprend trois étapes 404, 406, 408.

Dans une première étape 404, une couche brute de départ de plaque de transduction piézoélectrique est fournie. La couche brute de départ de la plaque de transduction est constituée en un matériau piézoélectrique et ferroélectrique, ayant une épaisseur de couche brute eb, et une étendue spatiale dans un plan perpendiculaire à la direction de l'épaisseur nettement plus grande que l'épaisseur eb de la couche brute. La couche brute de départ comprend des premiers domaines de polarisation positive et des seconds domaines de polarisation négative, les premiers domaines et les seconds domaines étant répartis dans le sens d'une longueur de la couche brute en étant alternés selon un motif de répétition, le motif de répétition étant défini par un pas p et un rapport cyclique.

L'orientation cristallographique de la couche brute et la direction des polarisations ferroélectriques ont été au préalable choisies de sorte qu'il existe un plan de coupe cristallographique de la couche brute dans le sens de l'épaisseur eb et de la longueur de la couche brute pour lequel une tranche, découpée suivant le plan de coupe et ayant une épaisseur e2, réalise lorsqu'elle est enserrée par des électrodes métalliques formées dans des plans normaux à la direction de l'épaisseur e2 un transducteur piézoélectrique et ferroélectrique à polarisation alternée, dans lequel des ondes de volume guides se propagent dans le sens de la longueur de la tranche, avec un coefficient de couplage électro-acoustique supérieur ou égal à 0,01%.

Dans une deuxième étape 406, une plaque de transduction piézoélectrique et ferroélectrique est découpée dans le sens de l'épaisseur de la couche brute et partiellement ou totalement dans la couche brute de départ de plaque résonnante.

La plaque de transduction découpée a une épaisseur de plaque résonante e2, une première et une deuxième faces planes disposées en vis-à-vis, les faces planes possédant une longueur L, une largeur l et, la découpe est effectuée par un procédé d'usinage suivant la direction de plan de coupe, la largeur l de la plaque et l'épaisseur de la couche brute étant de même sens, le matériau et l'orientation cristallographique de la couche brute, la direction du plan de coupe, la longueur L, la largeur l, la deuxième épaisseur de la plaque résonnante étant configurés pour créer et piéger des ondes de volume à la fréquence de fonctionnement du transducteur entre ses deux faces planes, et pour créer un guide d'ondes de volume acoustiques guidées se propageant dans le sens de la longueur de la plaque de transduction.

Dans une troisième étape 408, une première et une deuxième électrodes métalliques sont déposées recouvrant au moins en partie et respectivement la première face et la deuxième face de la plaque résonnante. Les première et une deuxième électrodes métalliques sont au moins partiellement en vis-à-vis.

Pour une surface donnée, on peut ainsi grâce à l'invention multiplier le nombre de transducteurs de façon considérable selon au mois un facteur 10 en exploitant des coupes de monocristaux les plus avantageuses en termes de couplage électromécanique pour les applications aux filtres de fréquence, en termes de stabilité en température pour les applications aux sources stables de fréquence, en termes de sensibilité aux contraintes pour les applications aux capteurs, de manière générale en combinant ces diverses caractéristiques pour réaliser une fonction applicative donnée.

Les applications des transducteurs piézoélectriques et ferroélectriques décrits ci-dessus sont les suivantes :
- les filtres à fort couplage,
- les résonateurs à haute fréquence,
- les capteurs de température, d'accélération,
- les gyromètres,
- les capteurs de couple, d'accélération, de contraintes,
- les modulateurs acousto-optiques à fort confinement, à forte modulation,
- les résonateurs pour les capteurs et en particulier les capteurs sans fil interrogeables en bandes IFM, les
- résonateurs pour les capteurs à haute température (sur des matériaux tels que les niobate et tantalate de litihium stoechiométriques, les céramiques monocristallines à température de Curie élevée),
- les résonateurs pour des capteurs accélérométriques, gyroscopiques, gravimétriques,
- les éléments pour la modulation de signaux optiques par couplage acoustico-optiques.

Les matériaux exploitables pour ces opérations sont le niobate, le tantalate de lithium et le niobate de potassium pour les filtres à fort couplage et (potentiellement les céramiques piézoélectriques et les monocristaux céramiques de type relaxeur), le tétraborate de lithium. Pour les capteurs et en particulier pour les capteurs à haute température (électrodes adéquates choisies pour ce type d'application, soit le platine, l'iridium, le zirconium ou le rubidium ou tout autre électrode réputée robuste à la haute température), et de façon générale tout monocristal ferroélectrique disponible sous forme de plaque suffisamment épaisse (au minimum 200 µm) pour permettre l'usinage des barreaux tels que présentés.

Pour les niobate et tantalate de lithium, on peut réduire la sensibilité thermique des résonateurs en les recouvrant d'un dépôt de silice amorphe dont le coefficient de température de la fréquence est de signe positif et permet de compenser le signe négatif de celui de ces matériaux.

Ainsi, il est tiré le meilleur parti de propriétés de monocristaux remarquables en termes de couplage électromécanique, de très hautes vitesses de phase, de confinement, de couplage acousto-optique.

Ainsi des plaques de fine épaisseur, par exemple de 5µm permettent l'optimisation des points de fonctionnement sur une gamme spectrale allant de quelques dizaines de MHz jusqu'à plusieurs GHz.

Ainsi il est permis des modes de connexion entre transducteurs particulièrement avantageux pour les structures de filtres à éléments d'impédance, mais surtout l'utilisation d'ondes élastiques guidées dans des structures à forts coefficients de couplage et de qualité de la résonance pour des fréquences difficilement atteignables à l'aide des méthodes planaires classiques amincissement/polissage. La combinaison de telles structures avec de couches de propriétés choisies permet par exemple d'optimiser les propriétés des composants correspondants. Par exemple, la réalisation d'une plaque de niobate de lithium équipée d'électrode et recouvert d'une couche de silice d'épaisseur convenable permet de réaliser un résonateur à très fort couplage pouvant aller jusqu'à 23% compense des effets de température.

Le fait d'utiliser des ondes de cisaillement présentant une vitesse de phase élevée permet des applications à des fréquences de travail notablement plus élevées qu'avec des modes de surfaces « classiques ».

## Revendications

1. Transducteur piézoélectrique à ondes de volume fonctionnant à une fréquence prédéterminée f et comprenant :
un bloc de substrat (4 ; 64 ; 74), porteur, ayant une face plane (16) possédant une première épaisseur e1 suivant une normale de la face plane et constitué en un premier matériau, et
une plaque de transduction piézoélectrique (6 ; 36 ; 66 ; 76) ayant une première et une deuxième faces planes (8,10) disposées en vis-à-vis, possédant une longueur L, une largeur l et une deuxième épaisseur e2, et constituée en un deuxième matériau piézoélectrique,
une première et une deuxième électrodes métalliques (12,14 ;42,44 ;54,56) recouvrant au moins en partie et respectivement la première face (8) et la deuxième face (10) de la plaque de transduction piézoélectrique (6 ; 36; 66; 76) et au moins partiellement en vis à vis,
la plaque de transduction piézoélectrique (6 ; 36 ; 66 ; 76) est formée par une couche de matériau ferroélectrique qui comprend des premiers domaines de polarisation positive et des seconds domaines de polarisation négative, les premiers domaines et les seconds domaines étant répartis dans le sens de la longueur L de la plaque en étant alternés selon un motif de répétition, le motif de répétition étant défini par un pas p et un rapport cyclique, et
la plaque de transduction piézoélectrique (6 ; 36 ; 66 ; 76) est fixée perpendiculairement au voisinage de la face plane (16) du bloc de substrat (4 ; 64 ; 74) de sorte que la largeur de la plaque de transduction piézoélectrique (6 ; 36 ; 66 ; 76) et la première épaisseur du bloc de substrat (4 ; 64 ; 74) ont un même sens, et
le premier matériau, le deuxième matériau, la première épaisseur du bloc de substrat (4 ; 64 ; 74), la longueur L, la largeur l, la deuxième épaisseur e2 de la plaque de transduction (6 ; 36 ; 66 ; 76), le pas p sont configurés pour créer et piéger des ondes de volume à la fréquence de fonctionnement du transducteur guidées entre ses deux faces planes, les ondes acoustiques guidées se propageant dans le sens de la longueur L de plaque de transduction (6 ; 36 ; 66 ; 76).

2. Transducteur piézoélectrique à ondes de volume selon la revendication 1, dans lequel le matériau possède une coupe cristallographique notée ZX selon le standard IEEE Std-176 Révision 1949, l'axe cristallographique X et l'axe cristallographique Z étant respectivement dirigés selon la longueur L et la largeur l de la plaque de transduction piézoélectrique (6 ; 36 ; 66 ; 76), les axes de polarisation des domaines ferroélectriques étant colinéaires à l'axe Z et l'axe de périodisation étant dirigé selon l'axe X.

3. Transducteur piézoélectrique à ondes de volume selon la revendication 1, dans lequel le matériau possède trois axes cristallographiques X, Y, Z, une coupe cristallographique notée ZX selon le standard IEEE Std-176 Révision 1949, l'axe cristallographique Y et l'axe cristallographique Z étant respectivement dirigés selon la longueur L et la largeur l de la plaque de transduction piézoélectrique, les axes de polarisation des domaines ferroélectriques étant colinéaires à l'axe Z, et l'axe de périodisation étant dirigé selon l'axe Y.

4. Transducteur piézoélectrique à ondes de volume selon l'une quelconque des revendications 1 à 3, dans lequel un facteur de forme latéral Fl, défini comme le rapport de la largeur l de la plaque de transduction piézoélectrique (6 ; 36 ; 66 ; 76) sur la deuxième épaisseur e2 de la plaque de transduction piézoélectrique (6 ; 36 ; 66 ; 76), est supérieur ou égal à 5, de préférence supérieur ou égal à 10.

5. Transducteur piézoélectrique à ondes de volume selon l'une quelconque des revendications 1 à 4, dans lequel un facteur de forme longitudinal, défini comme le rapport de la longueur de la plaque de transduction (6 ; 36 ; 66 ; 76) sur l'épaisseur de la plaque résonnante (6 ; 36 ; 66 ; 76), est un multiple de longueurs d'ondes supérieur ou égal à 10, de préférence supérieur ou égal à 100, la longueur d'onde étant égale à la vitesse de la phase de l'onde divisée par la fréquence f.

6. Transducteur piézoélectrique à ondes de volume selon l'une quelconque des revendications 1 à 5, dans lequel la plaque de transduction piézoélectrique (6) et le bloc de substrat (4) sont constitués en un même matériau piézoélectrique et forment une pièce d'un seul tenant, dans lequel le bloc de substrat (4) comprend des premiers domaines de polarisation positive et des seconds domaines de polarisation négative, les premiers domaines et le seconds domaines du bloc du substrat étant répartis dans le sens de la longueur de la plaque avec la même répartition des polarisations ferroélectriques que celle de la plaque dans le sens de la longueur L.

7. Transducteur piézoélectrique selon l'une quelconque des revendications 1 à 6 comprenant un élément de fixation et/ou d'isolation acoustique (68 ;78) à la fréquence de fonctionnement f, distinct du bloc de substrat (64 ;74) et de la plaque de transduction piézoélectrique (66 ; 76), constitué en au moins un troisième matériau distinct des premier et deuxième matériau, l'élément de fixation et/ou de d'isolation acoustique (68 ; 78) étant compris dans l'ensemble constitué par une unique couche de colle, un miroir de Bragg formé d'un empilement de couches à impédances acoustiques contrastées.

8. Transducteur piézoélectrique selon l'une quelconque des revendications 1 à 7, dans lequel
la plaque de transduction piézoélectrique (6 ; 76) et le bloc de substrat (4 ; 74) sont constitués en un même matériau piézoélectrique et comprennent des domaines ferroélectriques polarisées selon un même motif avec des directions de polarisations et des sens identiques ;
la coupe cristallographique et les polarisations des domaines ferroélectriques de la plaque de transduction piézoélectrique (6 ; 76) sont configurés de sorte que des ondes de volume à polarisation transversale ou longitudinale sont crées avec un coefficient de couplage électroacoustique supérieur à 0,01% et guidées entre les deux électrodes (12, 14) en se propageant dans la direction de la longueur de la plaque.

9. Transducteur piézoélectrique selon l'une quelconque des revendications 1 à 8, **caractérisé en ce que** la plaque de transduction piézoélectrique (36) présente une zone d'étranglement (38) dans la sens de l'épaisseur sur toute sa longueur pour laquelle l'épaisseur de la plaque de transduction (36) passe par un minimum, et la plaque résonnante (36) étant fixée au bloc de substrat (4), la zone d'étranglement (38) est située au voisinage de la face plane du bloc de substrat (4).

10. Transducteur piézoélectrique selon l'une quelconque des revendications 1 à 9, dans lequel
le premier matériau est compris dans l'ensemble des matériaux formé par le carbone-diamant, le silicium, le saphir, le carbure de silicium, le quartz, le niobate de lithium, le tantalate de lithium, le niobate de potassium, les céramiques piézoélectriques, le quartz, le tétraborate de lithium, l'orthophosphate, de gallium, le langasite, la langatate, le langanite, la silice,
le deuxième matériau est compris dans l'ensemble des matériaux formé par l'oxyde plomb, le titane, le zirconium PZT, le tantalate de lithium LiTaO₃, le niobate de lithium LiNbO₃, le niobate de potassium PbTiO₃ et les matériaux ferroélectriques de haute qualité cristalline.

11. Transducteur piézoélectrique selon l'une quelconque des revendications 1 à 10, dans lequel
les électrodes métalliques (12, 14; 42, 44; 54, 56) sont fabriquées dans un matériau compris dans l'ensemble des matériaux formés par l'aluminium, le platine, l'iridium, le zirconium, le rubidium, le cuivre, le titane, le molybdène, le nickel, le tungstène, l'or, le poly-silicium, les alliages de ces différents métaux, et
leur épaisseur est répartie de façon à obtenir une répartition de masse localisée en frontière de la plaque résonnante et du bloc de substrat de façon à piéger et concentrer les ondes de volume à l'intérieur d'une zone locale de la plaque résonnante.

12. Procédé de fabrication d'un transducteur piézoélectrique à ondes de volume fonctionnant à une fréquence prédéterminée comprenant les étapes suivantes :
- fournir (404) une couche brute de départ de plaque de transduction piézoélectrique, la couche brute de départ de la plaque de transduction étant constituée en un matériau piézoélectrique et ferroélectrique, ayant une épaisseur de couche brute eb, et une étendue spatiale dans un plan perpendiculaire à la direction de l'épaisseur nettement plus grande que l'épaisseur eb de la couche brute, la couche brut de départ comprenant des premiers domaines de polarisation positive et des seconds domaines de polarisation négative, les premiers domaines et les seconds domaines étant répartis dans le sens d'une longueur de la couche brute en étant alternés selon un motif de répétition, le motif de répétition étant défini par un pas p et un rapport cyclique, et l'orientation cristallographique de la couche brute et la direction des polarisations ferroélectriques ayant été au préalable choisies de sorte qu'il existe un plan de coupe cristallographique de la couche brute dans le sens de l'épaisseur eb et de la longueur de la couche brute pour lequel une tranche, découpée suivant le plan de coupe et ayant une épaisseur e2, réalise lorsqu'elle est enserrée par des électrodes métalliques formées dans des plans normaux à la direction de l'épaisseur e2 un transducteur piézoélectrique ferroélectrique à polarisation alternée, dans lequel des ondes de volume guidées se propagent dans le sens de la longueur de la tranche, avec un coefficient de couplage électro-acoustique supérieur ou égal à 0,01%,
- découper dans le sens de l'épaisseur de la couche brute et partiellement ou totalement dans la couche brute de départ de plaque résonnante, une plaque de transduction piézoélectrique ayant une épaisseur de plaque résonante e2, une première et une deuxième faces planes disposées en vis-à-vis, les faces planes possédant une longueur L, une largeur l et, la découpe étant effectuée par un procédé d'usinage suivant la direction de plan de coupe, la largeur l de la plaque et l'épaisseur de la couche brute étant de même sens, le matériau et l'orientation cristallographique de la couche brut, la direction du plan de coupe, la longueur L, la largeur l, la deuxième épaisseur de la plaque résonnante étant configurés pour créer et piéger des ondes de volume à la fréquence de fonctionnement du transducteur entre ses deux faces planes, et pour créer un guide d'ondes acoustiques de volume guidées se propageant dans le sens de la longueur L de la plaque de transduction ;
- déposer une première et une deuxième électrodes métalliques recouvrant au moins en partie et respectivement la première face et la deuxième face de la plaque de transduction piézoélectrique, et au moins partiellement en vis-à-vis.

13. Procédé de fabrication d'un résonateur piézoélectrique à ondes de volume selon la revendication 12, comprenant les étapes suivantes :
découper partiellement dans la couche de départ et dans le sens de l'épaisseur de la couche de départ la plaque résonnante, la découpe partielle dans le sens de l'épaisseur de la couche brute étant effectuée par enlèvement d'un premier barreau adjacent à la plaque au travers de la première face, et d'un deuxième barreau adjacent à la plaque au travers de la deuxième face,
de façon à obtenir la plaque résonante et un bloc de substrat comme étant le reste de la couche brute après découpage des barreaux, porteur de la plaque et ayant une face plane de référence, la plaque étant fixée d'un seul tenant perpendiculairement à la face plane du bloc de substrat, la largeur l de la plaque étant ainsi une hauteur de la plaque par rapport au bloc de substrat.

14. Procédé de fabrication d'un transducteur piézoélectrique à ondes de volume selon la revendication 12, comprenant les étapes suivantes :
fournir une couche brute de substrat porteur ayant une épaisseur de couche brute de substrat porteur et constitué en un matériau de substrat, et
disposer entre la couche de substrat porteur et la couche brute de plaque de transduction au moins une couche destinée à former un élément de fixation et/ou d'isolation acoustique à la fréquence de fonctionnement, distincte de la couche brute de substrat et de couche brute de la plaque résonnante, constituées en au moins un troisième matériau distinct du matériau de couche brute de substrat et distinct de la couche brute de plaque résonante, l'au moins une couche formant l'élément de fixation et/ou de d'isolation acoustique étant comprise dans l'ensemble constitué par une unique couche de colle, un miroir de Bragg formé d'un empilement de couches à impédances acoustiques contrastées,
découper au moins la couche brut de plaque sur une certaine profondeur de façon à former la plaque de transduction piézoélectrique.

15. Procédé de fabrication selon l'une quelconque de revendications 12 à 13 **caractérisé en ce que** l'étape de découpe de la plaque résonante est réalisée par sciage.

## Patentansprüche

1. Piezoelektrischer Wandler mit Volumenwellen, der mit einer vorbestimmten Frequenz f verfährt und umfasst:
einen tragenden Substratblock (4; 64; 74) mit einer ebenen Fläche (16) mit einer ersten Stärke e1 gemäß einer Normalen der ebenen Fläche und gebildet aus einem ersten Material, und
eine piezoelektrische Wandlerplatte (6; 36; 66; 76) mit einer ersten und einer zweiten gegenüber angeordneten ebenen Fläche (8, 10) mit einer Länge L, einer Breite l und einer zweiten Stärke e2 und gebildet aus einem zweiten piezoelektrischen Material,
wobei eine erste und eine zweite Metallelektrode (12, 14; 42 ,44; 54, 56) mindestens zum Teil und jeweils die erste Fläche (8) und die zweite Fläche (10) der piezoelektrischen Wandlerplatte (6; 36; 66; 76) bedecken und mindestens teilweise gegenüber,
wobei die piezoelektrische Wandlerplatte (6; 36; 66; 76) von einer ferromagnetischen Materialschicht gebildet ist, die erste Bereiche positiver Polarisierung und zweite Bereiche negativer Polarisierung umfasst, wobei die ersten Bereiche und die zweiten Bereiche im Richtung der Länge L der Platte verteilt sind, wobei gemäß einem Wiederholungsmuster alternieren, wobei das Wiederholungsmuster von eine Teilung p und einem zyklischen Verhältnis bestimmt ist, und
wobei die piezoelektrische Wandlerplatte (6; 36; 66; 76) senkrecht im Bereich der ebenen Fläche (16) des Substratblocks (4; 64; 74) derart befestigt ist, dass die Breite der piezoelektrischen Wandlerplatte (6; 36; 66; 76) und die erste Stärke des Substratblocks (4; 64; 74) eine selbe Richtung haben, und
wobei das erste Material, das zweite Material, die erste Stärke des Substratblocks (4; 64; 74), die Länge L, die Breite l, die zweite Stärke e2 der Wandlerplatte (6; 36; 66; 76), die Teilung p konfiguriert sind, um Volumenwellen mit der Funktionsfrequenz des Wandlers zu erzeugen und einzufangen, die zwischen seinen zwei ebenen Flächen geführt werden, wobei sich die geführten Akustikwellen im Richtung der Länge L der Wandlerplatte (6; 36; 66; 76) verbreiten.

2. Piezoelektrischer Wandler mit Volumenwellen nach Anspruch 1, wobei das Material einen kristallografischen Schnitt ZX gemäß Standard IEEE Std-176 Revision 1949 besitzt, wobei die kristallografische Achse X und die kristallografische Achse Z jeweils gemäß der Länge L und der Breite l der piezoelektrischen Wandlerplatte (6; 36; 66; 76) ausgerichtet sind, wobei die Polarisationsachsen der ferroelektrischen Bereiche kolinear zur Achse Z sind und die Periodisierungsachse gemäß der Achse X ausgerichtet ist.

3. Piezoelektrischer Wandler mit Volumenwellen nach Anspruch 1, wobei das Material drei kristallografische Achsen X, Y, Z, einen kristallografischen Schnitt ZX gemäß dem Standard IEEE Std-176 Revision 1949 besitzt, wobei die kristallografische Achse Y und die kristallografische Achse Z jeweils gemäß der Länge L und der Breite l der piezoelektrischen Wandlerplatte ausgerichtet sind, wobei die Polarisationsachsen der ferroelektrischen Bereiche kolinear zur Achse Z sind und die Periodisierungsachse gemäß der Achse Y ausgerichtet ist.

4. Piezoelektrischer Wandler mit Volumenwellen nach einem der Ansprüche 1 bis 3, wobei ein lateraler Formfaktor Fl, definiert als das Verhältnis der Breite l der piezoelektrischen Wandlerplatte (6; 36; 66; 76) zur zweiten Stärke e2 der piezoelektrischen Wandlerplatte (6; 36; 66; 76) größer oder gleich 5, vorzugsweise größer oder gleich 10, ist.

5. Piezoelektrischer Wandler mit Volumenwellen nach einem der Ansprüche 1 bis 4, wobei ein länglicher Formfaktor, definiert als das Verhältnis der Länge der Wandlerplatte (6; 36; 66; 76) zur Stärke der Resonanzplatte (6; 36; 66; 76), ein Vielfaches von Wellenlängen größer oder gleich 10, vorzugsweise größer oder gleich 100, ist, wobei die Wellenlänge gleich der Geschwindigkeit der Phase der Welle ist, dividiert durch die Frequenz f, ist.

6. Piezoelektrischer Wandler mit Volumenwellen nach einem der Ansprüche 1 bis 5, wobei die piezoelektrische Wandlerplatte (6) und Substratblock (4) aus einem selben piezoelektrischen Material gebildet sind und ein zusammenhängendes Teil bilden, wobei der Substratblock (4) erste Bereiche positiver Polarisierung und zweite Bereiche negativer Polarisierung umfasst, wobei die ersten Bereiche und die zweiten Bereiche des Substratblocks im Richtung der Länge der Platte mit derselben Verteilung der ferroelektrischen Polarisierungen wie die der Platte im Richtung der Länge L verteilt sind.

7. Piezoelektrischer Wandler nach einem der Ansprüche 1 bis 6, der ein Befestigungs- und/oder akustisches Dämmungselement (68; 78) mit der Funktionsfrequenz f umfasst, das sich vom Substratblock (64; 74) und von der piezoelektrischen Wandlerplatte (66; 76) unterscheidet, gebildet aus mindestens einem dritten Material, das sich vom ersten und zweiten Material unterscheidet, wobei das Befestigungs- und/oder akustische Dämmungselement (68; 78) in der Einheit inbegriffen ist, die von einer einzigen Klebstoffschicht, einem Bragg-Spiegel, gebildet von einem Stapel von Schichten mit kontrastierenden Impedanzen, gebildet ist.

8. Piezoelektrischer Wandler nach einem der Ansprüche 1 bis 7, wobei
die piezoelektrische Wandlerplatte (6; 76) und der Substratblock (4; 74) aus einem selben piezoelektrischen Material gebildet sind und ferroelektrische Bereiche umfassen, die gemäß einem selben Muster polarisiert sind, mit identischen Polarisationsrichtungen und Sinn,
wobei der kristallografischen Schnitt und die Polarisierungen der ferroelektrischen Bereiche der piezoelektrischen Wandlerplatte (6; 76) derart konfiguriert sind, dass Volumenwellen mit Quer- oder Längspolarisation mit einem elektroakustischem Kopplungskoeffizienten über 0,01 % gebildet und zwischen den zwei Elektroden (12, 14) geführt werden, indem sie sich in die Richtung der Länge der Platte verbreiten.

9. Piezoelektrischer Wandler nach einem der Ansprüche 1 bis 8, **dadurch gekennzeichnet, dass** die piezoelektrische Wandlerplatte (36) eine Verengungszone (38) im Richtung der Stärke über ihre gesamte Länge, für welche die Stärke der Wandlerplatte (36) einem Minimum ausstellt, aufweist, und die Resonanzplatte (36) am Substratblock (4) befestigt ist, wobei sich die Verengungszone (38) in der Nähe der ebenen Fläche des Substratblocks (4) befindet.

10. Piezoelektrischer Wandler nach einem der Ansprüche 1 bis 9, wobei
das erste Material zu der Materialgruppe gehört, die von dem Kohlenstoffdiamanten, dem Silizium, dem Saphir, dem Siliciumcarbid, dem Quarz, dem Lithiumniobat, dem Lithiumtantalat, dem Kaliumniobat, den piezoelektrischen Keramiken, dem Quarz, dem Lithiumtetraborat, dem Galliumorthophosphat, dem Langasit, dem Langatat, dem Langanit, der Kieselsäure gebildet ist,
wobei das zweite Material zu der Materialgruppe gehört, die von dem Bleioxid, dem Titan, dem Zirkonium PZT, dem Lithiumtantalat LiTa0₃, dem Lithiumniobat LiNb0₃, dem Kaliumniobat PbTi0₃ und den ferroelektrischen Materialien mit hoher kristalliner Qualität gebildet ist.

11. Piezoelektrischer Wandler nach einem der Ansprüche 1 bis 10, wobei
die Metallelektroden (12, 14; 42, 44; 54, 56) aus einem Material hergestellt sind, die zu der Materialgruppe gehören, die von dem Aluminium, dem Platin, dem Iridium, dem Zirkonium, dem Rubidium, dem Kupfer, dem Titan, dem Molybdän, dem Nickel, dem Wolfram, dem Gold, dem Polysilizium, den Legierungen dieser unterschiedlichen Metalle gebildet ist, und
ihre Stärke derart verteilt ist, dass eine Massenverteilung, an der Grenze der Resonanzplatte und des Substratblocks lokalisiert, erreicht wird, die derart ist, dass die Volumenwellen im Innern einer lokalen Zone der Resonanzplatte eingefangen und konzentriert werden.

12. Verfahren zur Herstellung eines piezoelektrischen Wandlers mit Volumenwellen, der mit einer vorbestimmten Frequenz verfährt, das die folgenden Schritte umfasst:
- Bereitstellen (404) einer unbearbeiteten Ausgangsschicht einer piezoelektrischen Wandlerplatte, wobei die unbearbeitete Ausgangsschicht der Wandlerplatte aus einem piezoelektrischen und ferroelektrischen Material mit einer Stärke der unbearbeiteten Schicht eb und einer räumlichen Ausdehnung in einer Ebene senkrecht zur Richtung der Stärke, die deutlich größer ist als die Stärke eb der unbearbeiteten Schicht, besteht, wobei die unbearbeitete Ausgangsschicht erste Bereiche positiver Polarisierung und zweite Bereiche negativer Polarisierung umfasst, wobei die ersten Bereiche und die zweiten Bereiche im Richtung einer Länge der unbearbeiteten Schicht verteilt sind, wobei sie gemäß einem Wiederholungsmuster alternieren, wobei das Wiederholungsmuster von einer Teilung p und einem zyklischen Verhältnis bestimmt ist,
und wobei die kristallografische Ausrichtung der unbearbeiteten Schicht und die Richtung der ferroelektrischen Polarisierungen zuvor derart gewählt wurden, dass eine kristallografische Schnittebene der unbearbeiteten Schicht im Richtung der Stärke eb und der Länge der unbearbeiteten Schicht besteht, wobei eine Scheibe, geschnitten gemäß der Schnittebene und mit einer Stärke e2, wenn sie von Metallelektroden eingeschlossen ist, die in normalen Ebene zur Richtung der Stärke e2 gebildet sind, einen ferroelektrischen piezoelektrischen Wandlers mit alternierender Polarisierung ergibt, wobei sich geführte Volumenwellen mit einem elektroakustischen Kopplungskoeffizienten größer oder gleich 0,01 % im Richtung der Länge der Scheibe verbreiten,
- Schneiden, im Richtung der Stärke der unbearbeiteten Schicht und teilweise oder vollständig in der unbearbeiteten Ausgangsschicht der Resonanzplatte, einer piezoelektrischen Wandlerplatte mit einer Resonanzplattenstärke e2, einer ersten und einer zweiten ebenen, gegenüber angeordneten Fläche, wobei die ebenen Flächen eine Länge L, eine Breite l besitzen und der Schnitt mit Hilfe eines Bearbeitungsverfahrens gemäß der Richtung der Schnittebene durchgeführt wird, wobei die Breite l der Platte und die Stärke der unbearbeiteten Schicht denselbe Richtung haben, wobei das Material und die kristallografische Ausrichtung der unbearbeiteten Schicht, die Richtung der Schnittebene, die Länge L, die Breite l, die zweite Stärke der Resonanzplatte konfiguriert sind, um Volumenwellen mit der Funktionsfrequenz des Wandlers zwischen seinen zwei ebenen Fläche zu erzeugen und einzufangen, und um einen Leiter geführter akustischer Volumenwellen zu erzeugen, die sich im Richtung der Länge L der Wandlerplatte verbreiten;
- Aufbringen einer ersten und einer zweiten Metallelektrode, die mindestens zum Teil und jeweils die erste Fläche und die zweite Fläche der piezoelektrischen Wandlerplatte bedecken und mindestens teilweise gegenüber.

13. Verfahren zur Herstellung eines piezoelektrischen Wandlers mit Volumenwellen nach Anspruch 12, das die folgenden Schritte umfasst:
teilweise Schneiden der Resonanzplatte aus der Ausgangsschicht und im Richtung der Stärke der Ausgangsschicht, wobei das teilweise Schneiden im Richtung der Stärke der unbearbeiteten Schicht durch Entfernen eines ersten an der Platte anliegenden Stabs durch die erste Fläche und eines zweiten an der Platte anliegenden Stabs durch die zweite Fläche erfolgt,
um die Resonanzplatte und einen Substratblock als Rest der der unbearbeiteten Schicht nach Schneiden der Stäbe zu erhalten, als Träger der Platte mit einer ebenen Referenzfläche, wobei die Platte zusammenhängend senkrecht auf der ebenen Fläche des Substratblocks befestigt ist, wobei dadurch die Breite l der Platte eine Höhe der Platte im Verhältnis zum Substratblock ist.

14. Verfahren zur Herstellung eines piezoelektrischen Wandlers mit Volumenwellen nach Anspruch 12, das die folgenden Schritte umfasst:
Bereitstellen einer tragenden unbearbeiteten Substratschicht mit einer Stärke einer tragenden unbearbeiteten Substratschicht und gebildet aus einem Substratmaterial, und
Anordnen zwischen der tragenden Substratschicht und der unbearbeiteten Schicht einer Wandlerplatte mindestens einer Schicht, die zur Bildung eines Befestigungs- und/oder akustischen Dämmungselements mit Funktionsfrequenz bestimmt ist, die sich von der unbearbeiteten Substratschicht und der unbearbeiteten Schicht der Resonanzplatte unterscheidet, gebildet aus mindestens einem dritten Material, das sich vom Material der unbearbeiteten Substratschicht unterscheidet und sich von der unbearbeiteten Schicht der Resonanzplatte unterscheidet, wobei die mindestens eine Schicht, die das Befestigungs- und/oder akustische Dämmungselement bildet, in der Einheit inbegriffen ist, die von einer einzigen Klebstoffschicht, einem Bragg-Spiegel, gebildet von einem Stapel von Schichten mit kontrastierenden Impedanzen, gebildet ist,
Schneiden mindestens der unbearbeiteten Schicht der Platte in einer bestimmten Tiefe, um die piezoelektrische Wandlerplatte zu bilden.

15. Herstellungsverfahren nach einem der Ansprüche 12 bis 13, **dadurch gekennzeichnet, dass** der Schritt des Schneidens der Resonanzplatte durch Sägen durchgeführt wird.

## Claims

1. A bulk wave piezoelectric transducer operating at a predetermined frequency f and comprising:
a block of substrate (4; 64; 74), as holding means, with a plane face (16) having a first thickness e1 along a normal to the plane face and consisting in a first material, and
a piezoelectric transduction plate (6; 36; 66; 76) having first and second plane faces (8,10) positioned facing each other, having a length L, a width I and a second thickness e2, and consisting in a second piezoelectric material,
first and second metal electrodes (12,14;42,44;54,56) covering at least partly the first face (8) and the second face (10) of the piezoelectric transduction plate (6; 36; 66; 76) respectively and at least partly facing each other,
wherein
the piezoelectric transduction plate (6; 36; 66; 76) is formed by a ferroelectric material layer which comprises first domains with a positive polarization and second domains with a negative polarization, the first domains and the second domains being distributed in the direction of the length L of the piezoelectric transduction plate alternately according to a repetition pattern, the repetition pattern being defined by a pitch p and a cyclic ratio, and
the piezoelectric transduction plate (6; 36; 66; 76) is attached perpendicularly in the vicinity of the plane face (16) of the block of substrate (4; 64; 74) so that the width of the piezoelectric transduction plate (6; 36; 66; 76) and the first thickness of the block of substrate (4; 64; 74) have a same direction, and
the first material, the second material, the first thickness of the block of substrate (4; 64; 74), the length L, the width I, the second thickness e2 of the piezoelectric transduction plate (6; 36; 66; 76), the pitch p are configured in order to generate and trap bulk waves at the operating frequency of the transducer, which are guided between the two plane faces of the piezoelectric transduction plate, the guided acoustic waves propagating in the direction of the length L of the transduction plate (6; 36; 66; 76).

2. The bulk wave piezoelectric transducer according to claim 1, wherein the second piezoelectric material has a crystallographic cut noted ZX according to the IEEE Std-176 standard revised in 1949, a crystallographic axis X and a crystallographic axis Z being respectively directed along the length L and the width l of the piezoelectric transduction plate (6; 36; 66; 76), a polarization axis of the ferroelectric domains being collinear with the Z axis and a repetition axis being directed along the X axis.

3. The bulk wave piezoelectric transducer according to claim 1, wherein the second piezoelectric material has three crystallographic axes X, Y, Z, a crystallographic cut noted ZX according to the IEEE Std-176 standard revised in 1949, the crystallographic axis Y and the crystallographic axis Z being respectively directed along the length L and the width l of the piezoelectric transduction plate, the polarization axis of the ferroelectric domains being collinear with the Z axis, and the repetition axis being directed along the Y axis.

4. The bulk wave piezoelectric transducer according to any of claims 1 to 3, wherein a lateral form factor Fl, defined as the ratio of the width l of the piezoelectric transduction plate (6; 36; 66; 76) over the second thickness e2 of the piezoelectric transduction plate (6; 36; 66; 76), is greater than or equal to 5, preferably greater than or equal to 10.

5. The bulk wave piezoelectric transducer according to any of claims 1 to 4, wherein a longitudinal form factor, defined as the ratio of the length of the piezoelectric transduction plate (6; 36; 66; 76) over the thickness of the piezoelectric transduction plate (6; 36; 66; 76), is a multiple of a wavelength, which is greater than or equal to 10, preferably greater than or equal to 100, the wavelength being equal to the phase velocity of a wave divided by the frequency f.

6. The bulk wave piezoelectric transducer according to any of claims 1 to 5, wherein the piezoelectric transduction plate (6) and the block of substrate (4) consist in a same piezoelectric material and form a part in one piece, wherein the block of substrate (4) comprises first domains of positive polarization and second domains of negative polarization, the first domains and the second domains of the block of substrate being distributed in the direction of the length of the plate with the same distribution of the ferroelectric polarization as that of the piezoelectric transduction plate in the direction of the length L.

7. The piezoelectric transducer according to any of claims 1 to 6, comprising an attachment element and/or an acoustic insulation element (68;78) at the operating frequency f, which is distinct from the block of substrate (64;74) and from the piezoelectric transduction plate (66; 76), consisting in at least one third material distinct from the first and second materials, the attachment element and/or the acoustic insulation element (68; 78) being comprised in the set formed by a single adhesive layer, a Bragg mirror formed with a stack of layers with contrasting acoustic impedances.

8. The piezoelectric transducer according to any of claims 1 to 7, wherein
the piezoelectric transduction plate (6; 76) and the block of substrate (4; 74) consist in a same piezoelectric material and comprise ferroelectric domains polarized according to a same repetition pattern with identical direction and orientation of the polarization;
the crystallographic cut and the polarizations of the ferroelectric domains of the piezoelectric transduction plate (6; 76) are configured so that bulk waves with transverse or longitudinal polarizations are generated with an electroacoustic coupling coefficient greater than 0.01% and guided between the two electrodes (12, 14) while propagating in the direction of the length of the piezoelectric transduction plate.

9. The piezoelectric transducer according to any of claims 1 to 8, wherein the piezoelectric transduction plate (36) has a constriction area (38) in the direction of the thickness and over the whole of the length thereof, for which the thickness of the piezoelectric transduction plate (36) passes by a minimum, and the piezoelectric transduction plate (36) being attached to the block of substrate (4), the constriction area (38) is located in the vicinity of the plane face of the block of substrate (4).

10. The piezoelectric transducer according to any of claims 1 to 9, wherein
the first material is comprised in the set of materials formed by diamond-carbon, silicon, sapphire, silicon carbide, quartz, lithium niobate, lithium tantalate, potassium niobate, piezoelectric ceramics, quartz, lithium tetraborate, gallium orthophosphate, langasite, langatate, langanite, silica,
the second material is comprised in the set of materials formed by lead oxide, titanium, PZT zirconium, lithium tantalate LiTaO₃, lithium niobate LiNbO₃, potassium niobate PbTiO₃, and ferroelectric materials with a high crystalline quality.

11. The piezoelectric transducer according to any of claims 1 to 10, wherein
the metal electrodes (12, 14; 42, 44; 54, 56) are made in a material comprised in the set of materials formed by aluminum, platinum, iridium, zirconium, rubidium, copper, titanium, molybdenum, nickel, tungsten, gold, poly-silicon, the alloys of these different metals, and
the thickness of the metal electrodes is distributed so as to obtain a distribution of mass localized at the boundary of the piezoelectric transduction plate and of the block of substrate so as to trap and concentrate the bulk waves inside a local area of the piezoelectric transduction plate.

12. A method for manufacturing a bulk wave piezoelectric transducer operating at a predetermined frequency comprising the following steps:
- providing (404) an initial piezoelectric transduction plate crude layer, the initial piezoelectric transduction plate crude layer consisting in a piezoelectric and ferroelectric material, having a crude layer thickness eb, and a spatial extent in a plane perpendicular to the direction of the thickness clearly greater than the thickness eb of the crude layer, the initial crude layer comprising first domains of positive polarization and second domains of negative polarization, the first domains and the second domains being distributed in the direction of a length of the crude layer alternately according to a repetition pattern, the repetition pattern being defined by a pitch p and a cyclic ratio,
and the crystallographic orientation of the crude layer and the direction of the ferroelectric polarizations having been selected beforehand so that there exists a crystallographic cut plane of the crude layer in the direction of the thickness eb and of the length of the crude layer for which a wafer, cut out according to the cut plane and having a thickness e2, produces, when it is placed between plane metal electrodes with a normal in the direction of the thickness e2, a ferroelectric piezoelectric transducer with alternating polarizations, wherein guided bulk waves propagate in the direction of the length of the wafer, with an electro-acoustic coupling coefficient greater than or equal to 0.01%,
- cutting out in the direction of the thickness of the crude layer and partly or totally in the initial resonant plate crude layer, a piezoelectric transduction plate having a resonant plate thickness e2, first and second plane faces positioned facing each other, the plane faces having a length L, a width I, and the cutting out being performed with a machining process along the cut plane direction, the width l of the plate and the thickness of the crude layer being in a same direction, the material and the crystallographic orientation of the crude layer, the direction of the cut plane, the length L, the width I, the second thickness of the resonant plate being configured for generating and trapping bulk waves at the operating frequency of the transducer between the two plane faces, and for creating a guide for acoustic bulk waves propagating in the direction of the length L of the piezoelectric transduction plate;
- depositing first and second metal electrodes covering at least partly the first face and the second face of the piezoelectric transduction plate respectively, and at least partly facing each other.

13. The method for manufacturing a bulk wave piezoelectric resonator according to claim 12, comprising the following steps:
partly cutting out in the initial layer and in the direction of the thickness of the initial layer, the piezoelectric transduction plate, the partial cutting out in the direction of the thickness of the crude layer being performed by removing a first bar adjacent to the plate through the first face, and a second bar adjacent to the plate through the second face,
so as to obtain the piezoelectric transduction plate and a block of substrate as the remainder of the crude layer after cutting out the bars, holding the piezoelectric transduction plate and having a reference plane face, the piezoelectric transduction plate being attached in one piece perpendicularly to the plane face of the block of substrate, the width l of the piezoelectric transduction plate being thus a height of the piezoelectric transduction plate relatively to the block of substrate.

14. The method for manufacturing a bulk wave piezoelectric resonator according to claim 12, comprising the following steps:
providing a crude layer of a holding substrate having a holding substrate crude layer thickness and consisting in a substrate material, and
positioning, between the holding substrate layer and the piezoelectric transduction plate crude layer, at least one layer intended to form an attachment element and/or an acoustic insulation element at the operating frequency, which is distinct from the substrate crude layer and from the piezoelectric transduction plate crude layer, consisting in at least a third material distinct from the substrate crude layer material and distinct from the piezoelectric transduction plate crude layer material, said at least one layer forming the attachment element and/or the acoustic insulation element being comprised in the set formed by a single adhesive layer, a Bragg mirror formed with a stack of layers with contrasting acoustic impedances,
cutting out at least the piezoelectric transduction plate crude layer over a certain depth so as to form the piezoelectric transduction plate.

15. The method for manufacturing a bulk wave piezoelectric resonator according to any of claims 12 to 13, wherein the step of cutting out the piezoelectric transduction plate is carried out by sawing.
